# EUROPEAN PATENT APPLICATION

(11) **EP 4 318 584 A1**
(43) Date of publication of application: **07.02.2024**
(21) Application number: 22781679.0
(22) Date of filing: 01.04.2022
(51) Int. Cl.: H01L 25/075, H01L 33/08, H01L 33/44, H01L 27/12, H01L 33/38

(54) **UNIT PIXEL FOR LED DISPLAY AND DISPLAY DEVICE HAVING SAME**

(30) Priority: 01.04.2021 US 202163169512 P; 31.03.2022 US 202217709413
(71) Applicant: Seoul Viosys Co., Ltd., Ansan-si, Gyeonggi-do 15429 (KR)
(72) Inventor: JANG, Jong Min, Ansan-si Gyeonggi-do 15429 (KR); LEE, Sung Hyun, Ansan-si Gyeonggi-do 15429 (KR)
(74) Representative: Isarpatent
(86) International application number: PCT/KR2022/004677
(87) International publication number: WO 2022/211560

(57) **Abstract**

A unit pixel for an LED display and a display device having same are provided. The unit pixel according to an embodiment comprises: a first light emission stack; a second light emission stack disposed under the first light emission stack; and a third light emission stack disposed under the second light emission stack, wherein the first light emission stack has a mirror symmetric structure with respect to at least one vertical plane passing through the center, as seen in a plan view.

## Description

### [TECHNICAL FIELD]

The present disclosure relates to a unit pixel for an LED display that implements an image using a light emitting diode and a display apparatus having the same, and more particularly, to a unit pixel for an LED display capable of implementing a symmetrical light emitting pattern and a display apparatus having the same.

### [Background Art]

Light emitting diodes are inorganic light sources, which are used in various fields such as display apparatuses, automobile lamps, general lighting, and the like. The light emitting diodes have advantages such as longer lifespan, lower power consumption, and quicker response, than conventional light sources, and thus, they have been replacing the conventional light sources.

The conventional light emitting diodes have been generally used as backlight light sources in display apparatuses. However, LED displays that directly realize images using the light emitting diodes have been recently developed.

In general, the display apparatus displays various colors through mixture of blue, green, and red light. In order to realize various images, the display apparatus includes a plurality of pixels, each of the pixels includes sub-pixels of blue, green, and red light, a color of a certain pixel is determined based on colors of the sub-pixels, and images can be realized through a combination of such pixels.

LEDs can emit light of various colors depending on materials thereof, and thus, individual light emitting devices emitting blue, green, and red are arranged on a two-dimensional plane to provide a display apparatus. The individual light emitting devices correspond to sub-pixels, and blue, green, and red light emitting devices form one pixel.

However, when a pixel is formed using the individual light emitting devices emitting blue, green and red, it is difficult to implement a symmetrical light emitting pattern.

### [Disclosure]

### [Technical Problem]

Exemplary embodiments provide a unit pixel having an improved symmetry of light emitted from each sub-pixel and an LED display apparatus having the same.

### [Technical Solution]

A unit pixel according to an exemplary embodiment includes a first light emitting stack; a second light emitting stack disposed under the first light emitting stack; and a third light emitting stack disposed under the second light emitting stack, in which at least one light emitting stack among the first through third light emitting stacks has a mirror symmetrical structure with respect to at least one vertical plane passing through a center of the at least one light emitting stack in plan view.

A display apparatus according to an exemplary embodiment includes a circuit board and a unit pixel disposed on the circuit board, in which the unit pixel includes: a first light emitting stack; a second light emitting stack disposed under the first light emitting stack; and a third light emitting stack disposed under the second light emitting stack, in which at least one light emitting stack among the first through third light emitting stacks has a mirror symmetrical structure with respect to at least one vertical plane passing through a center of the at least one light emitting stack in plan view.

### [Description of Drawings]

FIG. 1 is a schematic plan view illustrating a display apparatus according to an exe mplary embodiment.
FIG. 2A is a schematic plan view illustrating a unit pixel according to an exemplary embodiment.
FIG. 2B is a schematic cross-sectional view taken along line A-A' of FIG. 2A.
FIG. 2C is a schematic cross-sectional view taken along line B-B' of FIG. 2A.
FIG. 3A is a schematic cross-sectional view illustrating a method of manufacturing a first sub-pixel of a unit pixel according to an exemplary embodiment.
FIG. 3B is a schematic cross-sectional view illustrating a method of manufacturing a second sub-pixel of a unit pixel according to an exemplary embodiment.
FIG. 3C is a schematic cross-sectional view illustrating a method of manufacturing a third sub-pixel of a unit pixel according to an exemplary embodiment.
FIG. 4 is a schematic cross-sectional view illustrating a stacked structure of a unit pixel according to an exemplary embodiment.
FIGS. 5A, 6A, 7A, 8A, 9A, 10A, 11A, 12A, 13A, 14A, and 15A are plan views illustrating a method of manufacturing a light emitting device according to an exemplary embodiment.
FIGS. 5B, 6B, 7B, 8B, 9B, 10B, 11B, 12B, 13B, 14B, and 15B are cross-sectional views taken along line A-A' of its corresponding plan view shown in FIGS. 5A, 6A, 7A, 8A, 9A, 10A, 11A, 12A, 13A, 14A, and 15A.
FIGS. 5C, 6C, 7C, 8C, 9C, 10C, 11C, 12C, 13C, 14C, and 15C are schematic cross-sectional views taken along line B-B' of its corresponding plan view shown in FIGS. 5A, 6A, 7A, 8A, 9A, 10A, 11A, 12A, 13A, 14A, and 15A.
FIG. 16A is a schematic plan view illustrating a shape of a unit pixel according to an exemplary embodiment.
FIG. 16B is a schematic plan view illustrating a shape of a unit pixel according to another exemplary embodiment.
FIG. 16c is a schematic plan view illustrating a shape of a unit pixel according to another exemplary embodiment.
FIG. 17 is a schematic plan view showing a unit pixel having light emitting devices R, G, and B arranged according to a prior art.
FIGS. 18A and 18B are graphs illustrating light emission patterns in X and Y directions of the unit pixel according to the prior art.
FIGS. 19A and 19B are graphs illustrating light emission patterns in X and Y directions of a unit pixel according to an exemplary embodiment, respectively.

### [Detailed Description of the illustrated exemplary embodiment s]

Hereinafter, embodiments will be described in detail with reference to the accompanying drawings. The following embodiments are provided by way of example so as to fully convey the spirit of the present disclosure to those skilled in the art to which the present disclosure pertains. Accordingly, the present disclosure is not limited to the embodiments disclosed herein and can also be implemented in different forms. In the drawings, widths, lengths, thicknesses, and the like of elements can be exaggerated for clarity and descriptive purposes. When an element or layer is referred to as being "disposed above" or "disposed on" another element or layer, it can be directly "disposed above" or "disposed on" the other element or layer or intervening elements or layers can be present. Throughout the specification, like reference numerals denote like elements having the same or similar functions.

According to an exemplary embodiment of the present disclosure, a unit pixel for an LED display is provided. A unit pixel according to an exemplary embodiment includes a first light emitting stack; a second light emitting stack disposed under the first light emitting stack; and a third light emitting stack disposed under the second light emitting stack, in which at least one light emitting stack among the first through third light emitting stacks has a mirror symmetrical structure with respect to at least one vertical plane passing through a center of the at least one light emitting stack in plan view.

The unit pixel may have a rectangular shape in plan view, and the at least one vertical plane may pass through a straight line parallel to an edge of the unit pixel.

The first light emitting stack may have a mirror symmetrical structure with respect to a vertical plane passing through a straight line parallel to a lateral edge of the unit pixel or a vertical plane passing through a straight line parallel to a vertical edge of the unit pixel.

In a particular exemplary embodiment, the first light emitting stack may have a mirror symmetrical structure with respect to each of the vertical plane passing through the straight line parallel to the lateral edge of the unit pixel and the vertical plane passing through the straight line parallel to the vertical edge of the unit pixel.

The first light emitting stack may have an octagonal, hexagonal, or rhombus shape, and further, the first light emitting stack may have a regular octagonal, regular hexagonal, or square shape.

The second light emitting stack may have a protrusion protruding to the outside of the first light emitting stack in plan view, and the protrusion of the second light emitting stack may be disposed in a diagonal direction of the unit pixel.

In addition, the second light emitting stack may have a mirror symmetrical structure with respect to one of the vertical plane passing through the straight line parallel to the lateral edge of the unit pixel and the vertical plane passing through the straight line parallel to the vertical edge of the unit pixel, and may have an asymmetrical structure with respect to the other one.

The third light emitting stack may have a mirror symmetrical structure with respect to the vertical plane passing through the straight line parallel to the lateral edge of the unit pixel or the vertical plane passing through the straight line parallel to the vertical edge of the unit pixel.

The third light emitting stack may have a rectangular shape in plan view, and in a particular exemplary embodiment, it may have a square shape.

The unit pixel may further include first through fourth connection electrodes electrically connected to the first through third light emitting stacks, and the first through fourth connection electrodes may be disposed in the diagonal direction of the unit pixel.

The unit pixel may further include a first insulation layer covering the first through third light emitting stacks; first through fourth pads disposed on the first insulation layer; and a second insulation layer covering the first through fourth pads, in which the first insulation layer may have contact holes allowing electrical connection to the first through third light emitting stacks, the first through fourth pads may be electrically connected to the first through third light emitting stacks through the contact holes, the second insulation layer may have through holes allowing electrical connection to the first through fourth pads, and the first through fourth connection electrodes may be electrically connected to the first through fourth pads through the through holes of the second insulation layer.

The unit pixel may further include: a first adhesive layer disposed between the first light emitting stack and the second light emitting stack; a second adhesive layer disposed between the second light emitting stack and the third light emitting stack; and a first adhesion enhancement layer disposed between the second adhesive layer and the second light emitting stack.

In addition, the unit pixel may further include a second adhesion enhancement layer disposed between the second adhesive layer and the third light emitting stack.

The first adhesion enhancement layer and the second adhesion enhancement layer may include a silicon oxide layer.

The unit pixel may further include a substrate disposed under the third light emitting stack.

A display apparatus according to an exemplary embodiment includes a circuit board and a unit pixel disposed on the circuit board, in which the unit pixel includes: a first light emitting stack; a second light emitting stack disposed under the first light emitting stack; and a third light emitting stack disposed under the second light emitting stack, in which at least one light emitting stack among the first through third light emitting stacks has a mirror symmetrical structure with respect to at least one vertical plane passing through a center of the at least one light emitting stack in plan view.

The unit pixel may have a rectangular shape in plan view, the at least one vertical plane may pass through a straight line parallel to an edge of the unit pixel, and the first light emitting stack may have a mirror symmetrical structure with respect to the at least one vertical plane.

The second light emitting stack may have a mirror symmetrical structure with respect to one of a vertical plane passing through a straight line parallel to a lateral edge of the unit pixel and a vertical plane passing through a straight line parallel to a vertical edge of the unit pixel, and may have an asymmetrical structure with respect to the other one.

The third light emitting stack may have a mirror symmetrical structure with respect to the vertical plane passing through the straight line parallel to the lateral edge of the unit pixel or the vertical plane passing through the straight line parallel to the vertical edge of the unit pixel.

Hereinafter, exemplary embodiments of the present disclosure will be described in detail with reference to the accompanying drawings. Hereinafter, a light emitting area of a unit pixel may be 10,000 µm² or less. In other exemplary embodiments, the unit pixel may have a light emitting area of 4,000 µm² or less, and further, 2,500 µm² or less. A total area of the unit pixel may be 10,000 µm² or more.

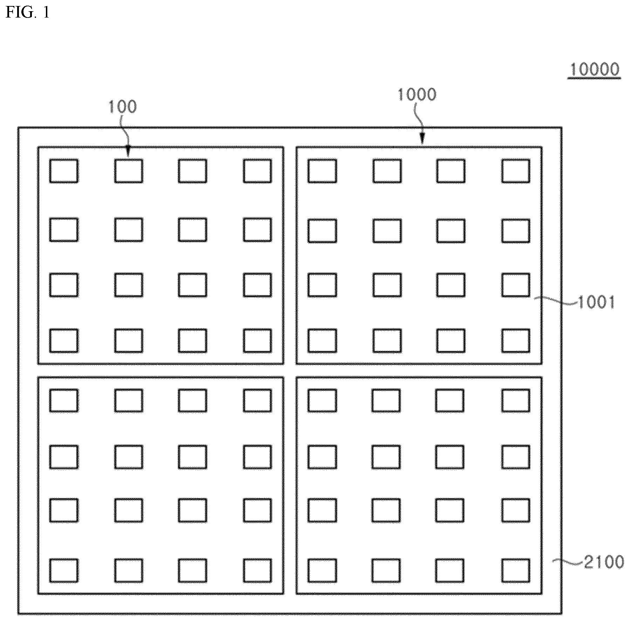

FIG. 1 is a schematic plan view illustrating a display apparatus according to an exemplary embodiment.

Referring to FIG. 1, a display apparatus 10000 may include a panel substrate 2100 and a plurality of pixel modules 1000.

The display apparatus 10000 is not particularly limited, but it may include a virtual reality (VR) display apparatus such as a micro LED TV, a smart watch, a VR headset, or an argument reality (AR) display apparatus such as augmented reality glasses.

The panel substrate 2100 may include a circuit for a passive matrix driving or active matrix driving manner. In an exemplary embodiment, the panel substrate 2100 may include wirings and resistors therein, and, in another exemplary embodiment, the panel substrate 2100 may include wirings, transistors, and capacitors. The panel substrate 2100 may also have pads that are capable of being electrically connected to the disposed circuit on an upper surface thereof.

In an exemplary embodiment, the plurality of pixel modules 1000 are arranged on the panel substrate 2100. Each of the pixel modules 1000 may include a circuit board 1001 and a plurality of unit pixels 100 disposed on the circuit board 1001, and may include a molding member covering the unit pixels 100. In another exemplary embodiment, the plurality of unit pixels 100 may be arranged directly on the panel substrate 2100, and the molding member may cover the unit pixels 100.

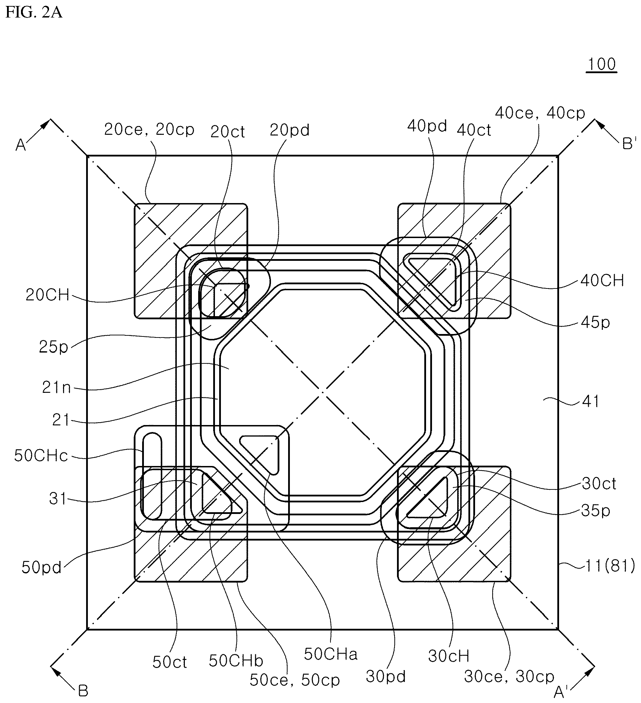

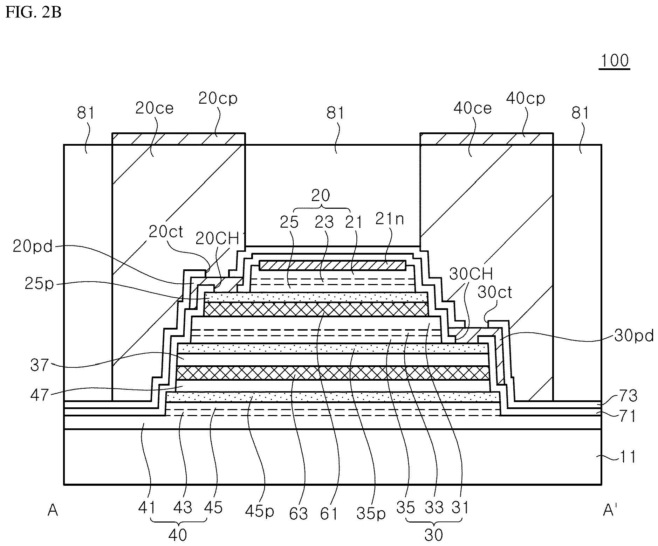

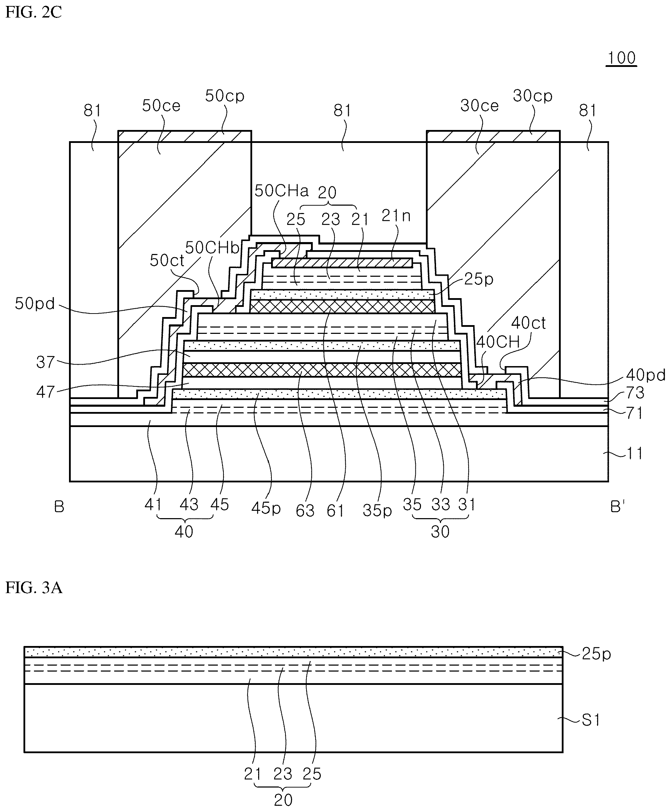

Each of the unit pixels 100 will be described in detail with reference to FIGS. 2A, 2B, and 2C.

FIG. 2A is a schematic plan view illustrating a unit pixel according to an exemplary embodiment, and FIG. 2B and FIG. 2C are schematic cross-sectional views taken al ong lines A-A' and B-B' of FIG. 2A.

Referring to FIGS. 2A, 2B, and 2C, the unit pixel 100 may include a light emitting stacked structure, a first connection electrode 20ce, a second connection electrode 30ce, a third connection electrode 40ce, and a fourth connection electrode 50ce formed on the light emitting stacked structure, and bonding metal layers 20cp, 30cp, 40cp, and 50cp may be disposed on each of the connection electrodes.

The unit pixel 100 may include a first LED sub-unit, a second LED sub-unit, and a third LED sub-unit disposed on a substrate 11. The first LED sub-unit may include a first light emitting stack 20, the second LED sub-unit may include a second light emitting stack 30, and the third LED sub-unit may include a third light emitting stack 40. While the drawings show the light emitting stacked structure including three light emitting stacks 20, 30, and 40, the inventive concepts are not limited to a particular number of light emitting stacks. For example, in some exemplary embodiments, the light emitting stacked structure may include two or more light emitting stacks therein. Hereinafter, the light emitting stacked structure will be described with reference to one that includes three light emitting stacks 20, 30, and 40 according to an exemplary embodiment.

The substrate 11 may include a light transmitting insulating material so as to transmit light therethrough. In some exemplary embodiments, however, the substrate 11 may be formed to be semi-transparent so as to transmit only light having a specific wavelength, or formed to be partially transparent so as to transmit only a portion of light having the specific wavelength. The substrate 11 may be a growth substrate capable of epitaxially growing the third light emitting stack 40 thereon, for example, a sapphire substrate. However, the inventive concepts are not limited thereto, and the substrate 11 may include various other transparent insulating materials. For example, the substrate 11 may include a glass, a quartz, a silicon, an organic polymer, or an organic-inorganic composite material, and may include, for example, a silicon carbide (SiC) substrate, a gallium nitride (GaN) substrate, an indium gallium nitride (InGaN) substrate, and aluminum gallium nitride (AlGaN) substrate, an aluminum nitride (AlN) substrate, a gallium oxide (Ga₂O₃) substrate, or a silicon substrate. In addition, the substrate 11 may include irregularities on an upper surface thereof, and it may be, for example, a patterned sapphire substrate. By including the irregularities on the upper surface, it is possible to increase an extraction efficiency of light generated from the third light emitting stack 40 in contact with the substrate 11. The irregularities of the substrate 11 may be employed so as to selectively increase a luminosity intensity of the third light emitting stack 40 compared to those of the first light emitting stack 20 and the second light emitting stack 30. Meanwhile, in another exemplary embodiment, the substrate 11 may be removed.

The first, second, and third light emitting stacks 20, 30, and 40 are configured to emit light towards the substrate 11. Accordingly, light emitted from the first light emitting stack 20 may pass through the second and third light emitting stacks 30 and 40. According to an exemplary embodiment, the first, second, and third light emitting stacks 20, 30, and 40 may emit light having different peak wavelengths from one another. In an exemplary embodiment, since the light emitting stack spaced apart far from the substrate 11 may emit light having a longer wavelength compared to that of the light emitting stack disposed close to the substrate 11, light loss may be reduced. For example, the first light emitting stack 20 may emit red light, the second light emitting stack 30 may emit green light, and the third light emitting stack 40 may emit blue light.

In another exemplary embodiment, the second light emitting stack 30 may emit light having a shorter wavelength than that of the third light emitting stack 40. A portion of light emitted from the second light emitting stack 30 may be absorbed by the third light emitting stack 40. Accordingly, it is possible to reduce the luminous intensity of the second light emitting stack 30 and increase the luminous intensity of the third light emitting stack 40, and thus, it is possible to change a luminous intensity ratio of light emitted from the first, second and third light emitting stacks. For example, the first light emitting stack 20 may be configured to emit red light, the second light emitting stack 30 to emit blue light, and the third light emitting stack 40 to emit green light. Accordingly, it is possible to relatively decrease the luminous intensity of blue light and relatively increase the luminous intensity of green light, and thus, it is possible to easily adjust the luminous intensity ratio of red, green, and blue to be close to 3:6:1. Furthermore, light emitting areas of the first, second, and third light emitting stacks 20, 30, and 40 may be about 10,000 µm² or less, further, 4,000 µm² or less, and further, 2,500 µm² or less. In addition, the closer the light emitting stack is to the substrate 11, the larger the light emitting area may be, and by disposing the third light emitting stack 40 emitting green light closest to the substrate 11, the luminous intensity of green light may be further increased.

Hereinafter, the second light emitting stack 30 has been exemplarily described as emitting light having the shorter wavelength than that of the third light emitting stack 40, but it should be noted that the second light emitting stack 30 may emit light having the longer wavelength than that of the third light emitting stack 40, for example, green light.

The first light emitting stack 20 includes a first conductivity type semiconductor layer 21, an active layer 23, and a second conductivity type semiconductor layer 25. According to an exemplary embodiment, the first light emitting stack 20 may include, a semiconductor material emitting red light such as AlGaAs, GaAsP, AlGaInP, and GaP, without being limited thereto.

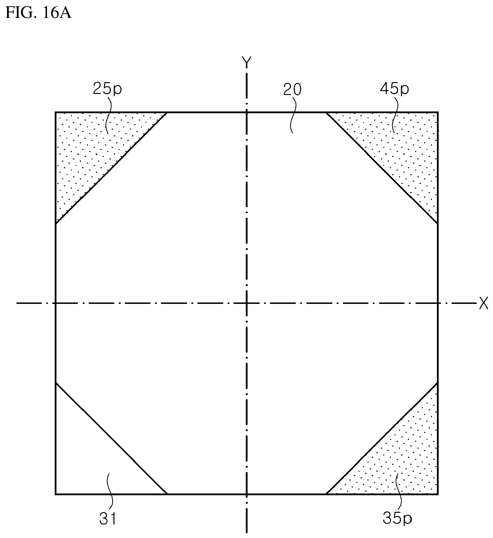

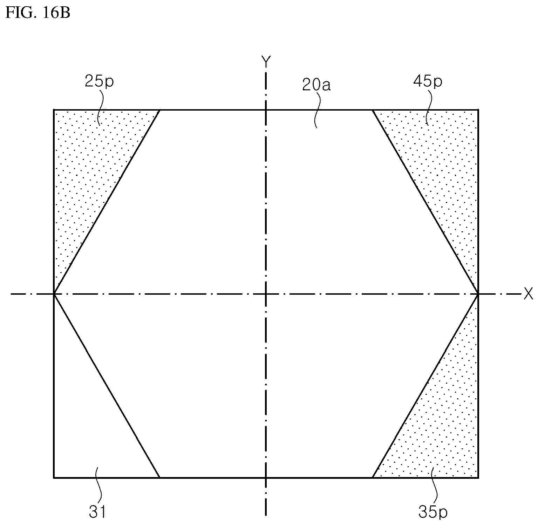

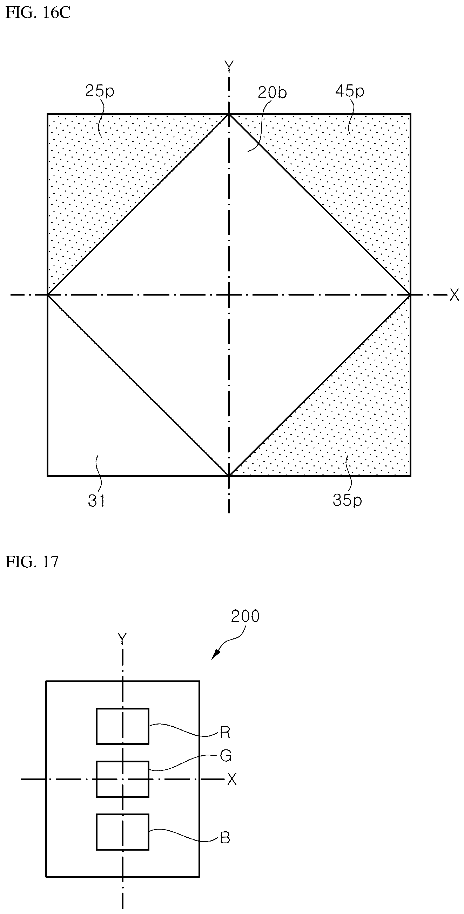

In an exemplary embodiment, the first light emitting stack 20 may have a symmetrical structure in plan view. For example, the first light emitting stack 20 may have a regular octagonal shape as shown in FIG. 2A. The symmetrical structure of the first light emitting stack 20 will be described in detail later with reference to FIGS. 16A, 16B, and 16C.

A first upper contact electrode 21n may be disposed on the first conductivity type semiconductor layer 21 and form an ohmic contact with the first conductivity type semiconductor layer 21. A first lower contact electrode 25p may be disposed under the second conductivity type semiconductor layer 25. According to an exemplary embodiment, a portion of the first conductivity type semiconductor layer 21 may be patterned to be recessed, and the first upper contact electrode 21n may be disposed in a recessed region of the first conductivity type semiconductor layer 21 so as to increase a level of ohmic contact. The first upper contact electrode 21n may have a single-layered structure or a multi-layered structure, and may include Al, Ti, Cr, Ni, Au, Ag, Sn, W, Cu, or an alloy thereof, for example, an Au-Te alloy or an Au-Ge alloy, without being limited thereto. In an exemplary embodiment, the first upper contact electrode 21n may have a thickness of about 100 nm, and may include a metal having a high reflectance so as to increase light emission efficiency in a downward direction toward the substrate 11.

The second light emitting stack 30 includes a first conductivity type semiconductor layer 31, an active layer 33, and a second conductivity type semiconductor layer 35. According to an exemplary embodiment, the second light emitting stack 30 may include a semiconductor material emitting blue light, such as GaN, InGaN, ZnSe, or the like, without being limited thereto. A second lower contact electrode 35p is disposed under the second conductivity type semiconductor layer 35 of the second light emitting stack 30.

The third light emitting stack 40 includes a first conductivity type semiconductor layer 41, an active layer 43, and a second conductivity type semiconductor layer 45. According to an exemplary embodiment, the third light emitting stack 40 may include a semiconductor material emitting green light, such as GaN, InGaN, GaP, AlGaInP, AlGaP, or the like. A third lower contact electrode 45p is disposed on the second conductivity type semiconductor layer 45 of the third light emitting stack 40.

According to an exemplary embodiment, each of the first conductivity type semiconductor layers 21, 31, and 41 and the second conductivity type semiconductor layers 25, 35, and 45 of the first, second, and third light emitting stacks 20, 30, and 40 may include a single-layered structure or a multi-layered structure, and in some exemplary embodiments, they may include a superlattice layer. Furthermore, the active layers 23, 33, and 43 of the first, second, and third light emitting stacks 20, 30, and 40 may have a single quantum well structure or a multi quantum well structure.

Each of the first, second, and third lower contact electrodes 25p, 35p, and 45p may include a transparent conductive material that transmits light. For example, the lower contact electrodes 25p, 35p, and 45p may include a transparent conductive oxide (TCO), for example, SnO, InO₂, ZnO, ITO, ITZO, or the like, without being limited thereto. The first lower contact electrode 25p may be thinner than the second and third lower contact electrodes 35p and 45p. For example, the first lower contact electrode 25p may be formed to have a thickness of about 240 nm, and the second and third lower contact electrodes 35p and 45p may be formed to have a thickness of about 300 nm.

A first adhesive layer 61 is disposed between the first light emitting stack 20 and the second light emitting stack 30, and a second adhesive layer 63 is disposed between the second light emitting stack 30 and the third light emitting stack 40. The first and second adhesive layers 61 and 63 may include a non-conductive material that transmits light. For example, the first and second adhesive layers 61 and 63 may include an optically clear adhesive (OCA), for example, epoxy, polyimide, SU8, spin-on-glass (SOG), benzocyclobutene (BCB), without being limited thereto.

A first adhesion enhancement layer 37 may be disposed between the second adhesive layer 63 and the second light emitting stack 30. For example, the first adhesive enhancement layer 37 may be disposed between the second adhesive layer 63 and the second lower contact electrode 35p to contact them. The first adhesion enhancement layer 37 may prevent the second light emitting stack 30 from being peeled off from the second adhesive layer 63 in a process involving a rapid stress change, such as a laser lift-off process, and furthermore, may prevent the second light emitting stack 30 from being cracked. The first adhesion enhancement layer 37 may be formed of, for example, a silicon oxide film, without being limited thereto.

A second adhesion enhancement layer 47 may be disposed between the second adhesive layer 63 and the third light emitting stack 40. For example, the second adhesive enhancement layer 47 may be disposed between the second adhesive layer 63 and the third lower contact electrode 45p to contact them. The second adhesion enhancement layer 47 may prevent the third light emitting stack 40 from being peeled off from the second adhesive layer 63 in a process involving a rapid stress change, such as a laser lift-off process, and furthermore, may prevent the third light emitting stack 40 from being cracked. The second adhesion enhancement layer 47 may be formed of, for example, a silicon oxide film, without being limited thereto.

The first and second adhesion enhancement layers 37 and 47 may have a thickness smaller than that of the second and third lower contact electrodes 35p and 45p, respectively, and may have a thickness of, for example, about 100 nm.

According to the illustrated exemplary embodiment, a first insulation layer 71 and a second insulation layer 73 are disposed on at least portions of sides of the first, second, and third light emitting stacks 20, 30, and 40. The first and second insulation layers 71 and 73 may include various organic or inorganic insulating materials, for example, polyimide, SiO₂, SiNx, Al₂O₃, or the like. For example, at least one of the first and second insulation layers 71 and 73 may include a distributed Bragg reflector DBR. As another example, at least one of the first and second insulation layers 71 and 73 may include a black organic polymer. In some exemplary embodiments, an electrically floating metallic reflection layer may be disposed on the first and second insulation layers 71 and 73 to reflect light emitted from the light emitting stacks 20, 30, and 40 toward the substrate 11. In some exemplary embodiments, at least one of the first and second insulation layers 71 and 73 may have a single-layered structure or a multi-layered structure formed of two or more insulation layers having different refractive indices from one another.

According to an exemplary embodiment, each of the first, second, and third light emitting stacks 20, 30, and 40 may be driven independently. More particularly, a common voltage may be applied to one of the first and second conductivity type semiconductor layers of each of the light emitting stacks, and a separate light emitting signal may be applied to another one of the first and second conductivity type semiconductor layers of each of the light emitting stacks. For example, according to an exemplary embodiment of the present disclosure, the first conductivity type semiconductor layers 21, 31, and 41 of each of the light emitting stacks may be n-type, and the second conductivity type semiconductor layers 25, 35, and 45 thereof may be p-type. In this case, the third light emitting stack 40 may have a stacked sequence that is reversed compared to those of the first light emitting stack 20 and the second light emitting stack 30, and accordingly, the p-type semiconductor layer 45 may be disposed over the active layer 43, so that a manufacturing process may be simplified. Hereinafter, according to the illustrated exemplary embodiment, the first conductivity type and the second conductivity type semiconductor layers may be expressed as n-type and p-type, respectively. Furthermore, the n-type and the p-type may be interchanged with each other.

The first, second, and third lower contact electrodes 25p, 35p, and 45p respectively connected to the p-type semiconductor layers 25, 35, and 45 of the light emitting stacks may be electrically connected to the first through third connection electrodes 20ce, 30ce, and 40ce, respectively, and receive a corresponding light emitting signal, respectively. Meanwhile, the n-type semiconductor layers 21, 31, and 41 of the light emitting stacks may be commonly electrically connected to the fourth connection electrode 50ce. Accordingly, the unit pixel 100 has a common n-type light emitting stacked structure in which the n-type semiconductor layers 21, 31, and 41 of the first, second, and third light emitting stacks 20, 30 and 40 are commonly connected, and may be driven independently of one another. Since it has the common n-type light emitting stacked structure, sources of voltages applied to the first, second, and third light emitting stacks 20, 30, and 40 may be different from one another.

The unit pixel 100 according to the illustrated exemplary embodiment has the common n-type structure, but the inventive concepts are not limited thereto. For example, in some exemplary embodiments, the first conductivity type semiconductor layers 21, 31, and 41 of each of the light emitting stacks may be p-type, and the second conductivity type semiconductor layers 25, 35, and 45 of each of the light emitting stacks may be n-type, and thus, it is possible to form a common p-type light emitting stacked structure. In addition, in some exemplary embodiments, the stacking sequence of each of the light emitting stacks is not limited to that illustrated in the drawings, but may be variously modified. Hereinafter, the unit pixel 100 according to an exemplary embodiment of the present disclosure will be described with reference to the common n-type light emitting stacked structure.

According to the illustrated exemplary embodiment, the unit pixel 100 includes a first pad 20pd, a second pad 30pd, a third pad 40pd, and a fourth pad 50pd. The first pad 20pd is electrically connected to the first lower contact electrode 25p through a first contact hole 20CH defined through the first insulation layer 71. The first connection electrode 20ce is electrically connected to the first pad 20pd through a first through hole 20ct defined through the second insulation layer 73. The second pad 30pd is electrically connected to the second lower contact electrode 35p through a second contact hole 30CH defined through the first insulation layer 71. The second connection electrode 30ce is electrically connected to the second pad 30pd through a second through hole 30ct defined through the second insulation layer 73.

The third pad 40pd is electrically connected to the third lower contact electrode 45p through a third contact hole 40CH defined through the first insulation layer 71. The third connection electrode 40ce is electrically connected to the third pad 40pd through a third through hole 40ct defined through the second insulation layer 73. The fourth pad 50pd is connected to the first conductivity type semiconductor layers 21, 31, and 41 of the first, second, and third light emitting stacks 20, 30, and 40 through a first sub-contact hole 50 CHa, a second sub-contact hole 50CHb, and a third sub-contact hole 50CHc defined through the first insulation layer 71 on the first conductivity type semiconductor layers 21, 31, and 41 of the first, second, and third light emitting stacks 20, 30, and 40. In particular, the first sub-contact hole 50CHa may expose the first upper contact electrode 21n, and the fourth pad 50pd may be connected to the first upper contact electrode 21n through the first sub-contact hole 50Cha. In this manner, the fourth pad 50pd may be electrically connected to the first conductivity type semiconductor layers 21, 31, and 41 through the sub-contact holes 50CHa, 50CHb and 50CHc, and thus, the manufacturing process of the unit pixel 100 may be simplified. The fourth connection electrode 50ce is electrically connected to the fourth pad 50pd through a fourth through hole 50ct defined through the second insulation layer 73.

In the illustrated exemplary embodiment, although the first through fourth connection electrodes 20ce, 30ce, 40ce, and 50ce are illustrated and described as directly contacting the pads 20pd, 30pd, 40pd, and 50pd, respectively, the first through fourth connection electrodes 20ce, 30ce, 40ce, and 50ce may not be directly connected to the pads 20pd, 30pd, 40pd, and 50pd, and another connector may be interposed therebetween.

The first, second, third, and fourth pads 20pd, 30pd, 40pd, and 50pd are spaced apart and insulated from one another. According to an exemplary embodiment, each of the first, second, third, and fourth pads 20pd, 30pd, 40pd, and 50pd may cover at least portions of the sides of the first, second, and third light emitting stacks 20, 30, and 40. Through this, heat generated from the first, second, and third light emitting stacks 20, 30, and 40 may be easily dissipated.

According to the illustrated exemplary embodiment, each of the connection electrodes 20ce, 30ce, 40ce, and 50ce may have a substantially elongated shape upward from the substrate 11. In an exemplary embodiment, the first through fourth connection electrodes 20ce, 30ce, 40ce, and 50ce may be disposed in a diagonal direction of the unit pixel 100. Accordingly, the light emitting area of the first through third light emitting stacks 20, 30, and 40 may be maximally secured.

The first through fourth connection electrodes 20ce, 30ce, 40ce, and 50ce may include a metal such as Cu, Ni, Ti, Sb, Zn, Mo, Co, Sn, Ag, or an alloy thereof, without being limited thereto. For example, each of the connection electrodes 20ce, 30ce, 40ce, and 50ce may include two or more metals or a plurality of different metal layers so as to reduce stress from the elongated shape of the connection electrodes 20ce, 30ce, 40ce, and 50ce. The first through fourth connection electrodes 20ce, 30ce, 40ce, and 50ce may be formed of, for example, Cu, which is advantageous in terms of deposition using plating and cost. Cu forms a natural oxide film, which can be removed by flux in a solder paste in a surface mount technology using the solder paste. However, in the surface mount technology using the solder paste, when a distance between the first through fourth connection electrodes 20ce, 30ce, 40ce, and 50ce is about 50 µm or less, an electrical short between the solder pastes may occur, so that the unit pixel 100 is not suitable for being mounted.

Eutectic bonding technology may be used as a method that can be used to bond light emitting devices of extremely small sizes, such as micro LEDs. However, the natural oxide film on Cu may interfere with eutectic bonding, and may cause a bonding failure.

Accordingly, in exemplary embodiments, the bonding metal layers 20cp, 30cp, 40cp, and 50cp may be disposed on the first through fourth connection electrodes 20ce, 30ce, 40ce, and 50ce, respectively. The bonding metal layers 20cp, 30cp, 40cp, and 50cp are electrically connected to the first through fourth connection electrodes 20ce, 30ce, 40ce, and 50ce, respectively. The bonding metal layers 20cp, 30cp, 40cp, and 50cp may be formed of a metallic layer that can be bonded to a circuit board through eutectic bonding, for example, Au or Au/In. In this case, a pad disposed on the circuit board may include, for example, In or Sn. It may be considered to form the bonding metal layers 20cp, 30cp, 40cp, and 50cp of In or Sn, but there are drawbacks that it is difficult to deposit In thickly through plating technology, and it is hard to probe Sn for measuring electrical characteristics of the unit pixel 100. Accordingly, by forming the bonding metal layers 20cp, 30cp, 40cp, and 50cp of Au, a bonding metal layer having a sufficient thickness may be formed, and further, the electrical characteristics of the unit pixel 100 may be easily measured.

Meanwhile, although not shown, a barrier layer may be interposed between the first through fourth connection electrodes 20ce, 30ce, 40ce, and 50ce and the bonding metal layers 20cp, 30cp, 40cp, and 50cp. The barrier layer prevents the bonding metal layers 20cp, 30cp, 40cp, and 50cp from being mixed with the connection electrodes 20ce, 30ce, 40ce, and 50ce.

A region between the first through fourth connection electrodes 20ce, 30ce, 40ce, and 50ce may be filled with a protection layer 81. The protection layer 81 may be formed of, for example, PDMA or black epoxy molding compound (EMC). The protection layer 81 may surround side surfaces of the first through fourth connection electrodes 20ce, 30ce, 40ce, and 50ce. The protection layer 81 may surround entire side surfaces of the first through fourth connection electrodes 20ce, 30ce, 40ce, and 50ce, and may expose upper surfaces thereof. In an exemplary embodiment, an upper surface of the protection layer 81 may be flush with the upper surfaces of the first through fourth connection electrodes 20ce, 30ce, 40ce, and 50ce. In another exemplary embodiment, the upper surfaces of the first through fourth connection electrodes 20ce, 30ce, 40ce, and 50ce may be recessed from the upper surface of the protection layer 81. In yet another exemplary embodiment, the upper surfaces of the first through fourth connection electrodes 20ce, 30ce, 40ce, and 50ce may protrude from the upper surface of the protection layer 81.

According to an exemplary embodiment, when the unit pixel 100 is a micro LED, which has a surface area less than about 10,000 µm² as known in the art, or less than about 4,000 µm² or 2,500 µm² in other exemplary embodiments, the connection electrodes 20ce, 30ce, 40ce, and 50ce may overlap a portion of at least one of the first, second, and third light emitting stacks 20, 30, and 40 as shown in the drawings. More particularly, the connection electrodes 20ce, 30ce, 40ce, and 50ce may overlap at least one step formed in a side surface of the light emitting stacked structure. As such, since an area of a lower surface of a connection electrode is greater than that of the upper surface thereof, a greater contacting area may be formed between the connection electrodes 20ce, 30ce, 40ce, and 50ce and the light emitting stacked structure. Accordingly, the connection electrodes 20ce, 30ce, 40ce, and 50ce may be more stably formed on the light emitting stacked structure, and heat generated in the light emitting stacked structure may be more efficiently dissipated to the outside.

In some exemplary embodiments, at least one of the first through fourth connection electrodes 20ce, 30ce, 40ce, and 50ce may overlap the side surface of each of the light emitting stacks 20, 30, and 40, and thus, heat generated in the light emitting stacks 20, 30, and 40 is efficiently dissipated to the outside. In addition, when the first through fourth connection electrodes 20ce, 30ce, 40ce, and 50ce include a reflective material such as metal, the first through fourth connection electrodes 20ce, 30ce, 40ce, and 50ce may reflect light emitted from at least one or more light emitting stacks 20, 30, and 40, and thus, light efficiency may be improved.

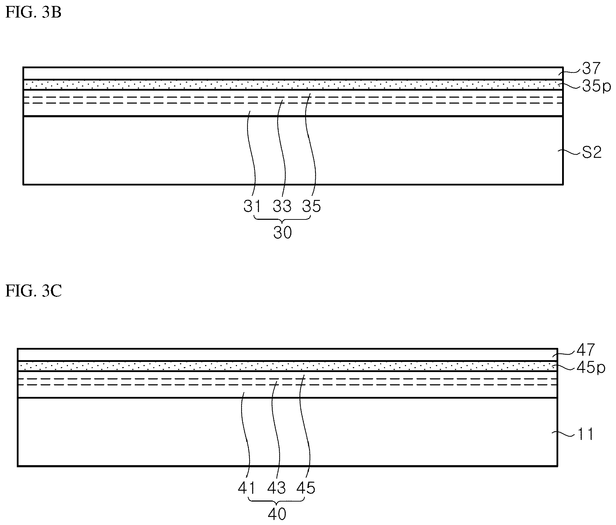

FIG. 3A is a schematic cross-sectional view illustrating a method of manufacturing a first LED sub-unit of a unit pixel according to an exemplary embodiment, FIG. 3B is a schematic cross-sectional view illustrating a method of manufacturing a second LED sub-unit of a unit pixel according to an exemplary embodiment, and FIG. 3C is a schematic cross-sectional view illustrating a method of manufacturing a third LED sub-unit of a unit pixel according to an exemplary embodiment.

Referring to FIG. 3A, a first light emitting stack 20 is grown on a first temporary substrate S1. The first temporary substrate S1 may be, for example, a GaAs substrate. In addition, the first light emitting stack 20 is formed of AlGaInP-based semiconductor layers, and includes a first conductivity type semiconductor layer 21, an active layer 23, and a second conductivity type semiconductor layer 25. A first lower contact electrode 25p may be formed on the second conductivity type semiconductor layer 25.

Referring to FIG. 3B, a second light emitting stack 30 is grown on a second temporary substrate S2, and a second lower contact electrode 35p is formed on the second light emitting stack 30. The second light emitting stack 30 may include a first conductivity type semiconductor layer 31, an active layer 33, and a second conductivity type semiconductor layer 35.

The second temporary substrate S2 is a substrate capable of growing a gallium nitride-based semiconductor layer, and may be, for example, a sapphire substrate. The second light emitting stack 30 may be formed so as to emit blue light. Meanwhile, the second lower contact electrode 35p is in ohmic contact with the second conductivity type semiconductor layer 35. Furthermore, a first adhesion enhancement layer 37 may be formed on the second lower contact electrode 35p. The first adhesion enhancement layer 37 may be formed of, for example, SiO₂.

Referring to FIG. 3C, a third light emitting stack 40 is grown on a substrate 11, and a third lower contact electrode 45p is formed on the third light emitting stack 40. The third light emitting stack 40 includes a first conductivity type semiconductor layer 41, an active layer 43, and a second conductivity type semiconductor layer 45.

A third substrate 11 is a substrate capable of growing a gallium nitride-based semiconductor layer, and may be, for example, a sapphire substrate. The third light emitting stack 40 may be formed so as to emit green light. The third lower contact electrode 45p is in ohmic contact with the second conductivity type semiconductor layer 45. Furthermore, a second adhesion enhancement layer 47 may be formed on the third lower contact electrode 45p. The second adhesion enhancement layer 47 may be formed of, for example, SiO₂.

The first conductivity type semiconductor layer 41, the active layer 43, and the second conductivity type semiconductor layer 45 of the third light emitting stack 40 may be sequentially grown on the substrate 11 by, for example, a metal organic chemical vapor deposition (MOCVD) method or a molecular beam epitaxy (MBE) method. The third lower contact electrode 45p may be formed on the second conductivity type semiconductor layer 45 by, for example, a physical vapor deposition method or a chemical vapor deposition method, and may include a transparent conductive oxide (TCO) such as SnO, InO₂, ZnO, ITO, or ITZO. When the third light emitting stack 40 according to an exemplary embodiment of the present disclosure emits green light, the substrate 11 may include Al₂O₃ (e.g., a sapphire substrate), and the third lower contact electrode 45p may include a transparent conductive oxide (TCO). The first and second light emitting stacks 20 and 30 may be similarly formed by sequentially growing the first conductivity type semiconductor layer, the active layer, and the second conductivity type semiconductor layer on the temporary substrates S1 and S2, respectively. The lower contact electrodes 25p and 35p including the transparent conductive oxide (TCO) may be formed on the second conductivity type semiconductor layers 25 and 35, respectively, by, for example, the physical vapor deposition method or the chemical vapor deposition method.

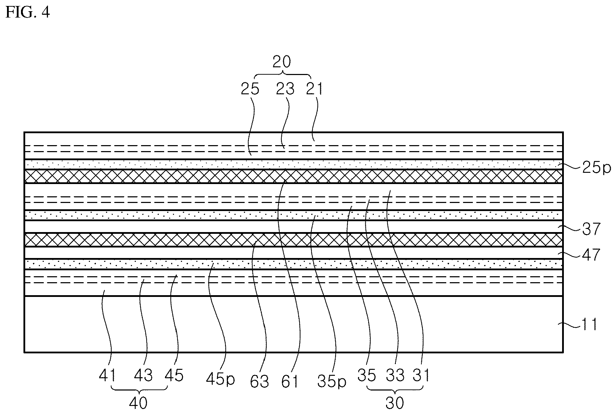

FIG. 4 is a schematic cross-sectional view illustrating a stacked structure of the unit pixel according to an exemplary embodiment. The stacked structure of the unit pixel is formed using the first through third LED sub-units described above with reference to FIGS. 3A, 3B, and 3C.

Referring to FIG. 4, first, the second light emitting stack 30 described with reference to FIG. 3B is bonded to the third light emitting stack 40 described with reference to FIG. 3C. For example, the first adhesion enhancement layer 37 and the second adhesion enhancement layer 47 may be bonded so as to face each other. A second adhesive layer 63 may be formed on the second adhesion enhancement layer 47, and the first adhesion enhancement layer 37 may be adhered to the second adhesive layer 63. The second adhesive layer 63 may be, for example, a transparent organic material layer or a transparent inorganic material layer. Examples of the organic layer include SU8, poly(methylmethacrylate) (PMMA), polyimide, parylene, benzocyclobutene (BCB), or the like, and examples of the inorganic layer include Al₂O₃, SiO₂, SiNx, or the like. The organic layers may be bonded under a high vacuum and a high pressure, and after surfaces thereof are planarized through, for example, chemical mechanical polishing, the inorganic layers may be bonded under a high vacuum by lowering a surface energy using plasma or the like.

Thereafter, the second temporary substrate S2 may be removed from the second light emitting stack 30 using a technique such as laser lift-off, chemical lift-off, or the like. In particular, the second temporary substrate S2 may be removed using the laser lift-off, and in this case, a sudden stress change may be induced in the second light emitting stack 30 and the second adhesive layer 63. The first and second adhesion enhancement layers 37 and 47 prevent the second light emitting stack 30 from being cracked or being peeled off from such a sudden stress change. Meanwhile, as the second temporary substrate S2 is removed, the first conductivity type semiconductor layer 31 of the second LED stack 30 is exposed upward. The exposed surface of the first conductivity type semiconductor layer 31 may be textured.

Subsequently, the first light emitting stack 20 is bonded to the second light emitting stack 30. In an exemplary embodiment, a first adhesive layer 61 may be formed on the first lower contact electrode 25p, and the first light emitting stack 20 may be coupled onto the second light emitting stack 30 using the first adhesive layer 61. Since the first adhesive layer 61 is formed on the first lower contact electrode 25p, the first adhesive layer 61 may be formed on the first light emitting stack 20 while the second light emitting stack 30 and the third light emitting stack 40 are bonded, and thus, a process time may be shortened. However, the inventive concepts are not limited thereto, and the first adhesive layer 61 may be formed on the second light emitting stack 30, and the first light emitting stack 20 may be coupled to the second light emitting stack 30.

Thereafter, the first temporary substrate S 1 is removed. The first temporary substrate S 1 may be removed from the first light emitting stack 20 using, for example, an etching technique. Accordingly, the light emitting stacked structure shown in FIG. 4 is provided. The above-described unit pixel 100 is formed by processing the light emitting stacked structure.

Hereinafter, a method of manufacturing the unit pixel 100 using the light emitting stacked structure of FIG. 4 will be described in detail.

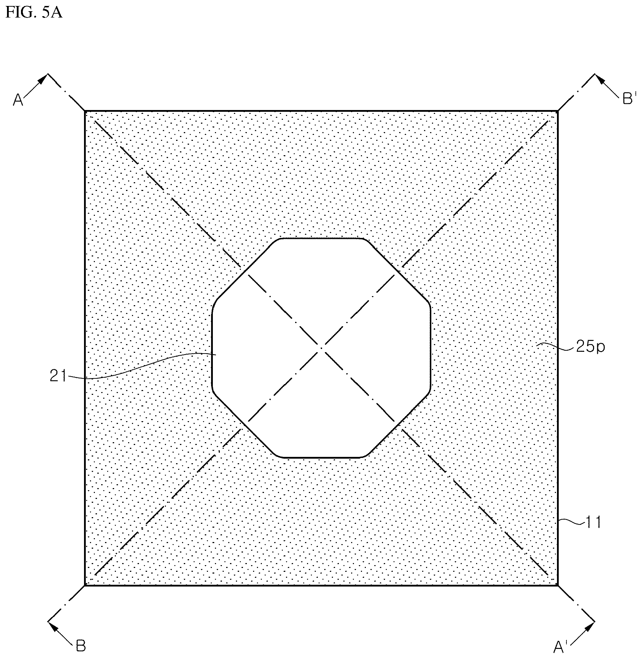

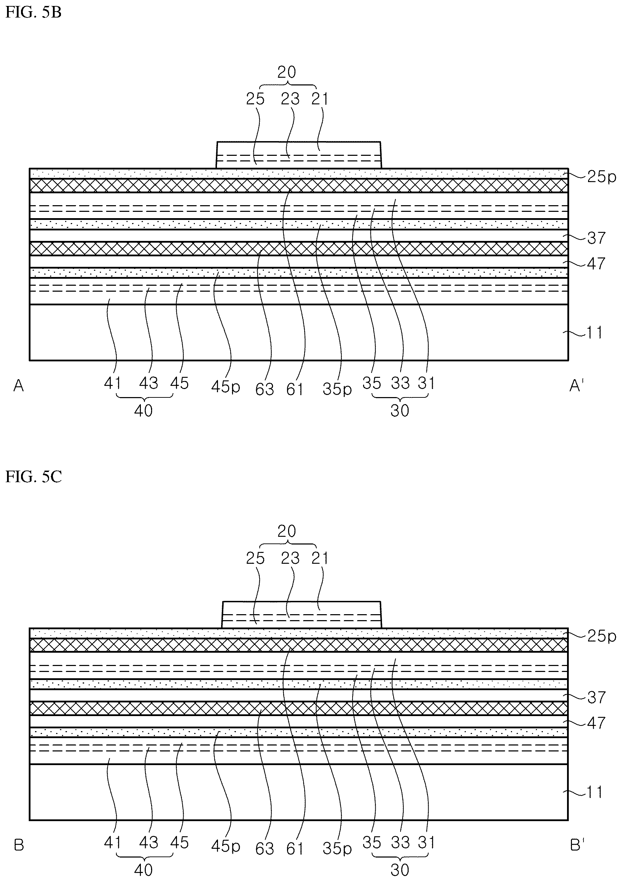

FIGS. 5A, 6A, 7A, 8A, 9A, 10A, 11A, 12A, 13A, 14A, and 15A are plan views illustrating a method of manufacturing the unit pixel 100 according to an exemplary embodiment. FIGS. 5B, 6B, 7B, 8B, 9B, 10B, 11B, 12B, 13B, 14B, and 15B are cross-sectional views taken along line A-A' of its corresponding plan view shown in FIGS. 5A, 6A, 7A, 8A, 9A, 10A, 11A, 12A, 13A, 14A, and 15A. FIGS. 5C, 6C, 7C, 8C, 9C, 10C, 11C, 12C, 13C, 14C, and 15C are schematic cross-sectional views taken along line B-B' of its corresponding plan view shown in FIGS. 5A, 6A, 7A, 8A, 9A, 10A, 11A, 12A, 13A, 14A, and 15A.

First, referring to FIGS. 5A, 5B and 5C, the first lower contact electrode 25p is exposed by patterning the first conductivity type semiconductor layer 21, the active layer 23, and the second conductivity type semiconductor layer 25. The first conductivity type semiconductor layer 21, the active layer 23, and the second conductivity type semiconductor layer 25 may be patterned using photolithography and etching processes. The photolithography process may be performed using a first mask, and the first conductivity type semiconductor layer 21, the active layer 23, and the second conductivity type semiconductor layer 25 may be etched, for example, using a dry etching technique. After patterning, the first light emitting stack 20 surrounded by the exposed lower contact electrode 25p remains. Although one first light emitting stack 20 is illustrated herein, the first light emitting stack 20 may be patterned in each of unit pixel regions on the substrate 11.

The first light emitting stack 20 may be disposed in a central portion of the unit pixel region, without being limited thereto. Meanwhile, a planar shape of the first light emitting stack 20 may have a symmetrical structure. For example, the planar shape of the first light emitting stack 20 may have a symmetrical structure such as a mirror symmetrical structure or a rotational symmetrical structure. The unit pixel 100 may have a rectangular or square shape, and the planar shape of the first light emitting stack 20 may have a mirror symmetrical structure with respect to a vertical plane passing through a straight line parallel to a lateral edge of the unit pixel and/ or a vertical plane passing through a straight line parallel to a vertical edge of the unit pixel. The planar shape of the first light emitting stack 20 may have, for example, an octagonal, hexagonal, or rhombus shape, and further, may have a regular octagonal, regular hexagonal, or square shape, without being limited thereto.

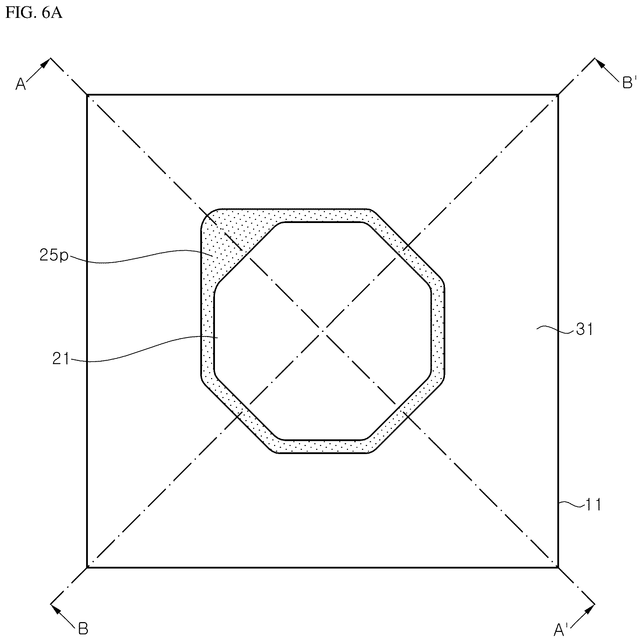

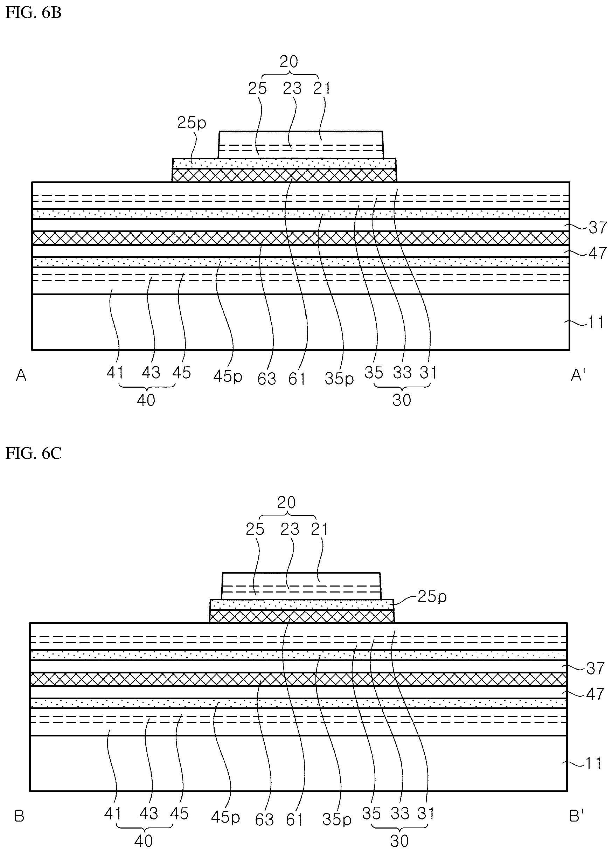

Referring to FIGS. 6A, 6B, and 6C, the first lower contact electrode 25p is patterned such that a portion of the first lower contact electrode 25p remains around the first light emitting stack 20. The first lower contact electrode 25p may be patterned using a second mask. In this case, the first adhesive layer 61 may also be patterned together. Accordingly, the first conductivity type semiconductor layer 31 of the second light emitting stack 30 may be exposed around the first lower contact electrode 25p.

A planar shape of the first lower contact electrode 25p is substantially similar to that of the first light emitting stack 20, except that a protrusion (a portion where an indicator line of the reference number 25p touches) is included on one side of the first light emitting stack 20. The protrusion is disposed in a diagonal direction of the unit pixel 100. A region excluding the protrusion may have a shape substantially identical to the planar shape of the first light emitting stack 20. In a particular exemplary embodiment, the first lower contact electrode 25p may have a mirror symmetrical structure with respect to a vertical plane passing through line A-A', and may have an asymmetrical structure with respect to a vertical plane passing through line B-B'.

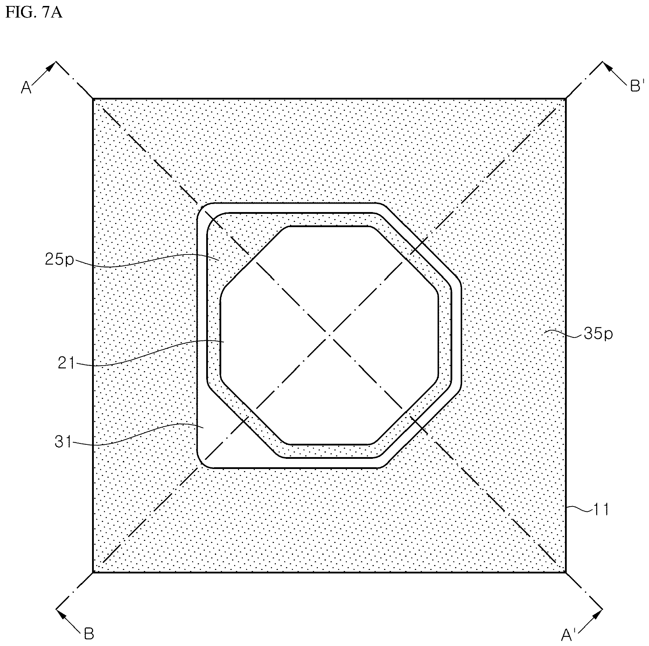

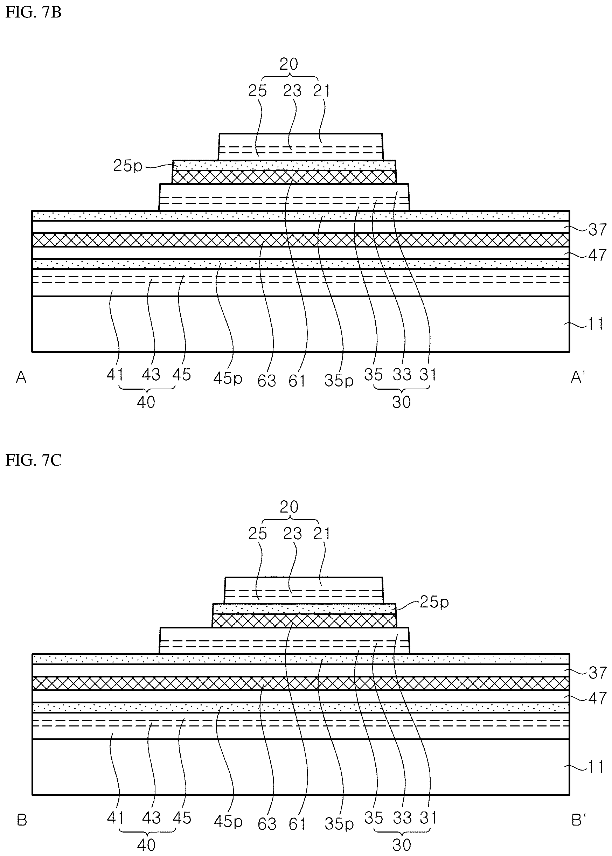

Referring to FIGS. 7A, 7B, and 7C, the second lower contact electrode 35p is exposed by patterning the first conductivity type semiconductor layer 31, the active layer 33, and the second conductivity type semiconductor layer 35. The first conductivity type semiconductor layer 31, the active layer 33, and the second conductivity type semiconductor layer 35 may be patterned using photolithography and etching processes. The photolithography process may be performed using a third mask, and the first conductivity type semiconductor layer 31, the active layer 33, and the second conductivity type semiconductor layer 35 may be etched using, for example, a dry etching technique. After patterning, the second light emitting stack 30 surrounded by the exposed second lower contact electrode 35p remains.

A planar shape of the second light emitting stack 30 is substantially similar to that of the first lower contact electrode 25p, except that a protrusion (a portion where an indicator line of the reference number 31 touches) is included on one side of the first lower contact electrode 25p. A region of the second light emitting stack 30 excluding the protrusion may have a shape substantially identical to the planar shape of the first lower contact electrode 25p. Accordingly, the second light emitting stack 30 has the shape substantially similar to the planar shape of the first light emitting stack 20, but has protrusions at two portions in the diagonal direction of the unit pixel 100. In a particular exemplary embodiment, the second light emitting stack 30 has a mirror symmetrical structure with respect to a vertical plane dividing an upper part from a lower part of the second light emitting stack 30, that is, the vertical plane passing through a straight line parallel to the lateral edge of the unit pixel 100. Except for the protrusion of the first lower contact electrode 25p and the protrusion of the second light emitting stack 30, the second light emitting stack 30 may have substantially the same planar shape as that of the first light emitting stack 20.

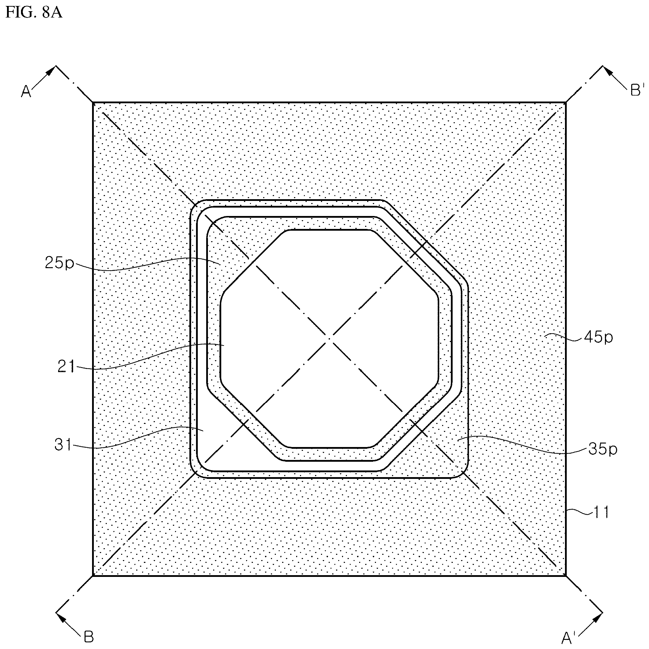

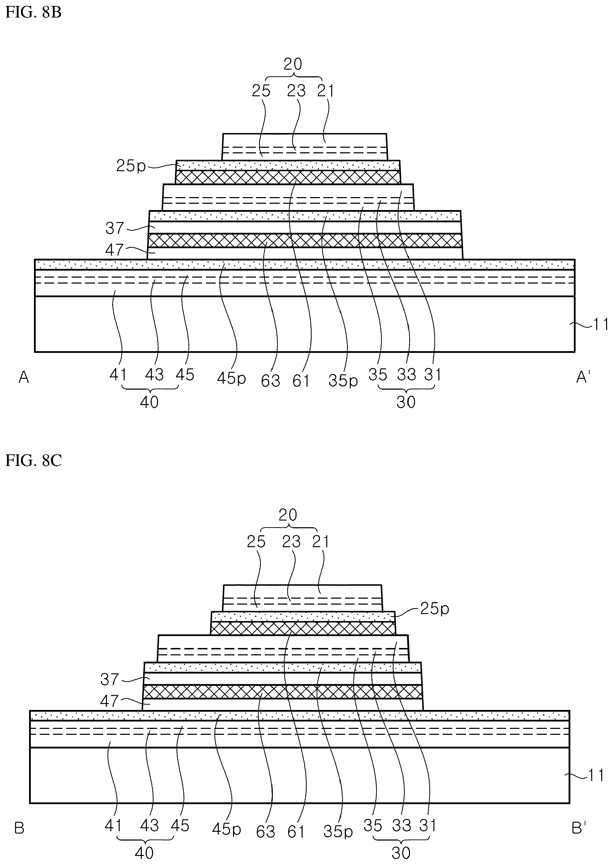

Referring to FIGS. 8A, 8B, and 8C, the second lower contact electrode 35p is patterned such that a portion of the second lower contact electrode 35p remains around the second light emitting stack 30. The second lower contact electrode 35p may be patterned using a fourth mask. In this case, the first adhesion enhancement layer 37, the second adhesive layer 63, and the second adhesion enhancement layer 47 may also be patterned together. Accordingly, the third lower contact electrode 45p may be exposed around the second lower contact electrode 35p.

A planar shape of the second lower contact electrode 35p is substantially similar to that of the second light emitting stack 30, except that a protrusion (a portion where an indicator line of the reference number 35p touches) is included on one side of the second light emitting stack 30. A region of the second lower contact electrode 35p excluding the protrusion may have a shape substantially identical to the planar shape of the second light emitting stack 30. In a particular exemplary embodiment, the second lower contact electrode 35p may have a mirror symmetrical structure with respect to the vertical plane passing through line B-B', and may have an asymmetrical structure with respect to the vertical plane passing through line A-A'.

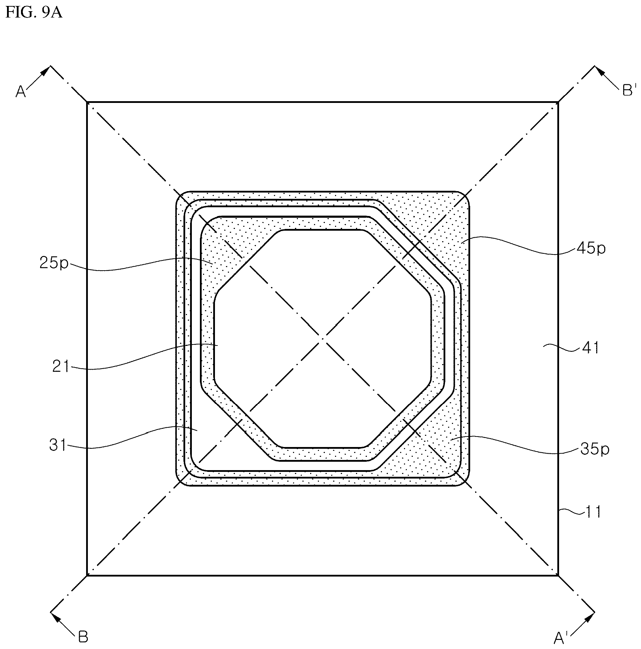

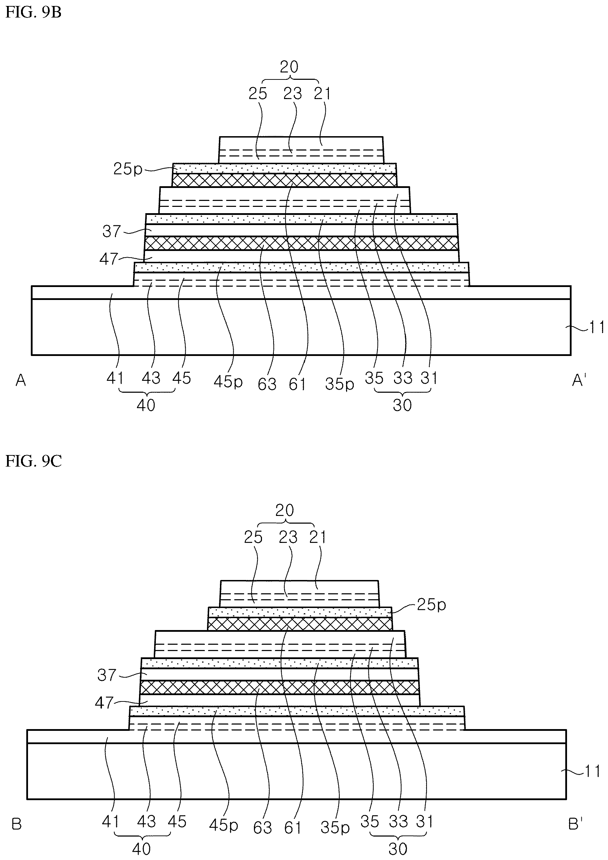

Referring to FIGS. 9A, 9B, and 9C, the third lower contact electrode 45p is patterned such that the third lower contact electrode 45p remains around the second lower contact electrode 35p. The third lower contact electrode 45p may be patterned using a fifth mask. Furthermore, the first conductivity type semiconductor layer 41 may be exposed by patterning the second conductivity type semiconductor layer 45 and the active layer 43. For example, the third lower contact electrode 45p, the second conductivity type semiconductor layer 45, and the active layer 43 may be etched using a dry etching technique. Accordingly, the first conductivity type semiconductor layer 41 is exposed around the third lower contact electrode 45p.

A planar shape of the third lower contact electrode 45p is substantially similar to that of the second lower contact electrode 35p, except that a protrusion (a portion where an indicator line of the reference number 45p touches) is included on one side of the second lower contact electrode 35p. A region of the third lower contact electrode 45p excluding the protrusion may have a shape substantially identical to the planar shape of the second lower contact electrode 35p. In a particular exemplary embodiment, the planar shape of the third lower contact electrode 45p may have a mirror symmetrical structure with respect to the vertical plane passing through line A-A', and may have an asymmetrical structure with respect to the vertical plane passing through line B-B'. Furthermore, the planar shape of the third lower contact electrode 45p may be substantially rectangular or square.

According to the illustrated exemplary embodiment, the first light emitting stack 20 has a smallest area among the light emitting stacks 20, 30, and 40. Meanwhile, the third light emitting stack 40 may have a largest area among the light emitting stacks 20, 30, and 40, and thus, a luminous intensity of the third light emitting stack 40 may be relatively increased.

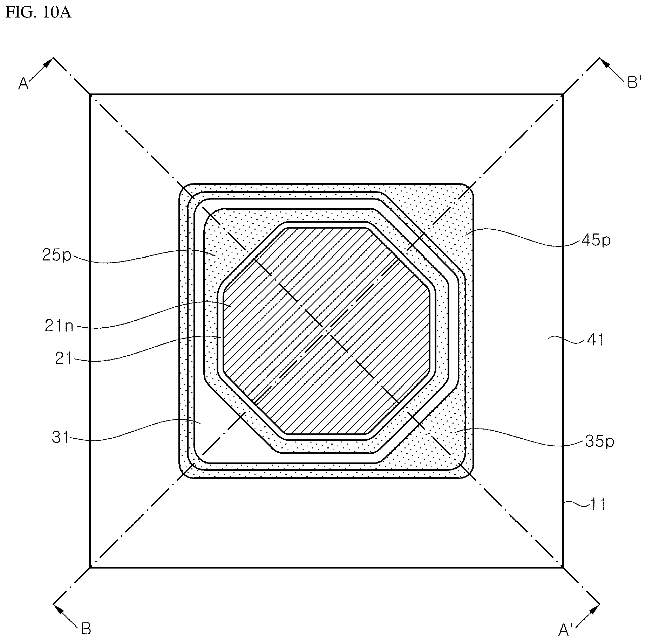

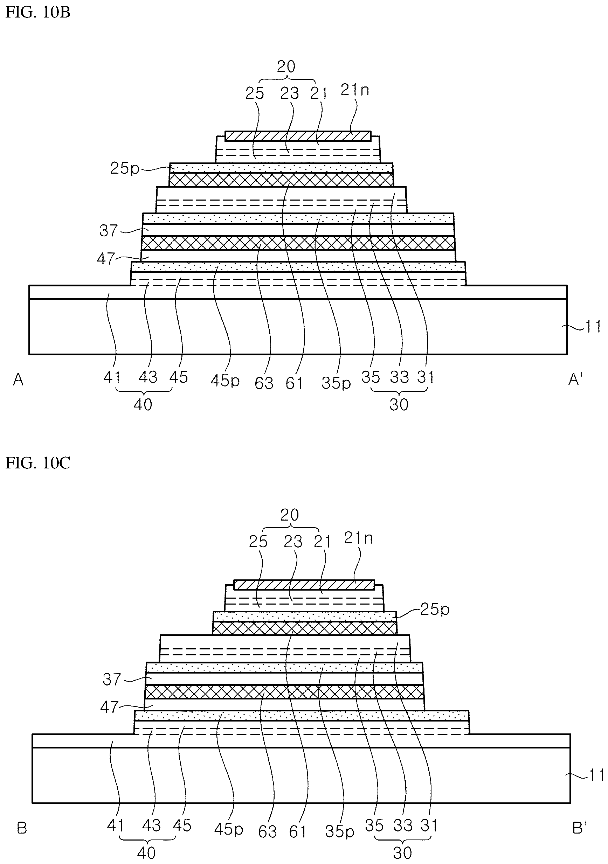

Referring to FIGS. 10A, 10B, and 10C, a portion of an upper surface of the first conductivity type semiconductor layer 21 of the first light emitting stack 20 may be patterned through wet-etching so as to form a first upper contact electrode 21n. The first conductivity type semiconductor layer 21 may be, for example, an n⁺⁺ GaAs layer, and a portion of an upper surface of the n⁺⁺ GaAs layer may be recessed through wet etching.

The first upper contact electrode 21n may be formed in a recessed region of the first conductivity type semiconductor layer 21. The first upper contact electrode 21n may be formed of, for example, AuGe/Ni/Au/Ti, and may have a thickness of, for example, 100 nm/25 nm/100 nm/10 nm. Ohmic contact characteristics may be improved by partially removing the surface of the n₊₊ GaAs layer and allowing the first upper contact electrode 21n to contact the first conductivity type semiconductor layer 21 in the recessed region.

The first upper contact electrode 21n may have an area smaller than that of the first light emitting stack 20. However, the first upper contact electrode 21n may have a planar shape substantially identical to that of the first light emitting stack 20.

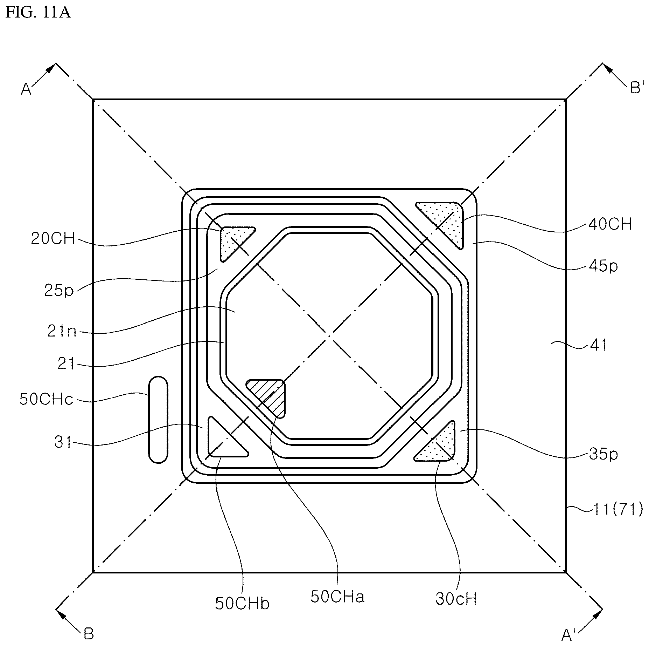

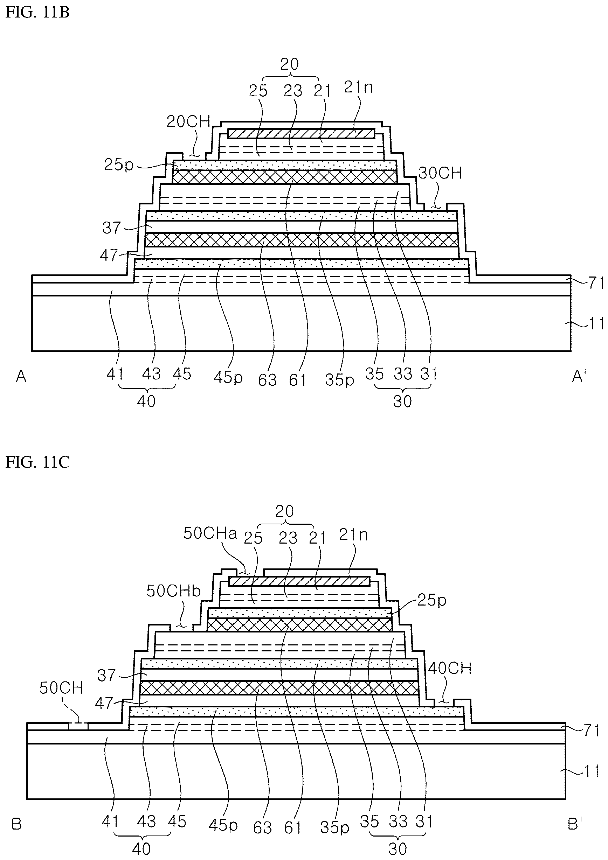

Referring to FIGS. 11A, 11B and 11C, a first insulation layer 71 covering the first through third light emitting stacks 20, 30, and 40 is formed. The first insulation layer 71 covers the first upper contact electrode 21n. The first insulation layer 71 may be formed of, for example, SiN, SiO₂, Al₂O₃, or the like to have a thickness of about 4000 Å.

Meanwhile, a portion of the first insulation layer 71 may be partially removed so as to form first, second, third, and fourth contact holes 20CH, 30CH, 40CH, and 50CH. The first contact hole 20CH is defined on the first lower contact electrode 25p to expose a portion of the first lower contact electrode 25p. The second contact hole 30CH may be defined on the second lower contact electrode 35p to expose the second lower contact electrode 35p. The third contact hole 40CH may be defined on the third lower contact electrode 45p to expose the third lower contact electrode 45p.

The fourth contact hole 50CH provides a path for allowing electrical connection to the first conductivity type semiconductor layers 21, 31, and 41 of the first through third light emitting stacks 20, 30, and 40. The fourth contact hole 50CH may include a first sub-contact hole 50CHa, a second sub-contact hole 50CHb, and a third sub-contact hole 50Chc. The first sub-contact hole 50CHa may be defined on the first conductivity type semiconductor layer 21 to expose a portion of the first upper contact electrode 21n, and the second sub-contact hole 50CHb may be defined on the first conductivity type semiconductor layer 31 to expose a portion of the first conductivity type semiconductor layer 31, and the third sub-contact hole 50CHc may be defined on the first conductivity type semiconductor layer 41 to expose a portion of the first conductivity type semiconductor layer 41.

The first contact hole 20CH, the second contact hole 30CH, the third contact hole 40CH, and the second sub-contact hole 50CHb may be disposed on the protrusions disposed at the outside of the first light emitting stack 20, respectively. Meanwhile, the first sub-contact hole 50Cha may be disposed on the first upper contact electrode 21n, and the third sub-contact hole 50CHc may be disposed on the first conductivity type semiconductor layer 41 at the outside of the third lower contact electrode 45p.

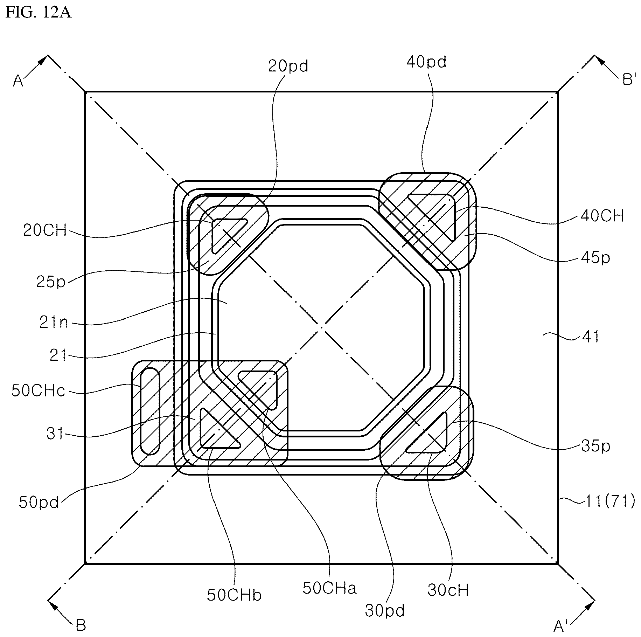

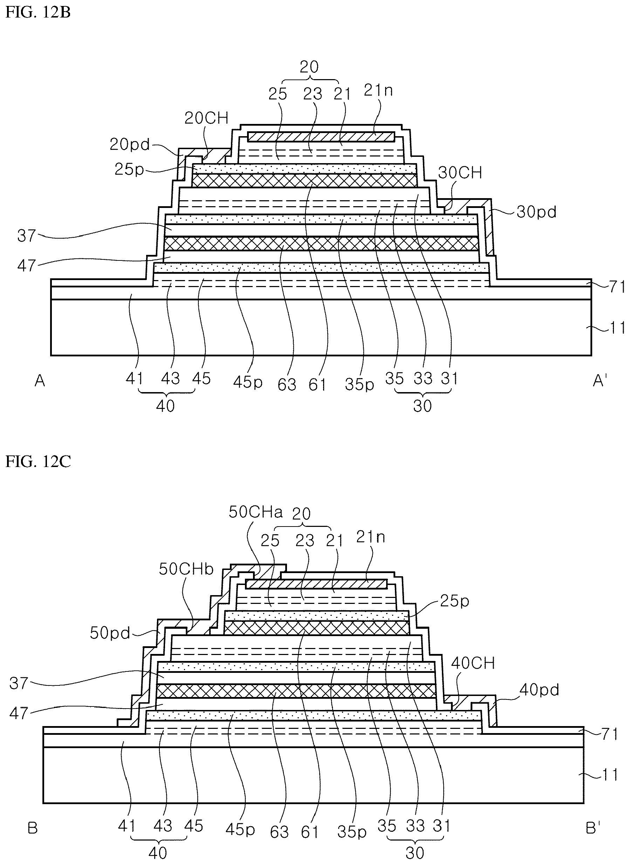

Referring to FIGS. 12A, 12B, and 12C, first, second, third, and fourth pads 20pd, 30pd, 40pd, and 50pd are formed on the first insulation layer 71. The first, second, third and fourth pads 20pd, 30pd, 40pd, and 50pd may be formed by, for example, forming a conductive layer on a substantially entire surface of the substrate 11 and patterning the conductive layer using photolithography and etching processes.

The first pad 20pd may be formed so as to overlap a region where the first contact hole 20CH is formed, and may be connected to the first lower contact electrode 25p through the first contact hole 20CH. The second pad 30pd may be formed so as to overlap a region where the second contact hole 30CH is formed, and may be connected to the second lower contact electrode layer 35p through the second contact hole 30CH. The third pad 40pd may be formed so as to overlap a region where the third contact hole 40CH is formed, and may be connected to the third lower contact electrode 45p through the third contact hole 40CH. The fourth pad 50pd may be formed so as to overlap a region in which the fourth contact hole 50CH is formed, in particular, a region in which the first, second, and third sub-contact holes 50CHa, 50CHb, and 50Chc are formed, and may be electrically connected to the first conductivity type semiconductor layers 21, 31, and 41 of the first through third light emitting stacks 20, 30, and 40.

The first through fourth pads 20pd, 30pd, 40pd, and 50pd may include Au, may be formed in, for example, a stacked structure of Ti/Ni/Ti/Ni/Ti/Ni/Au/Ti, and a thickness thereof may be, for example, about 100 nm/50 nm/100 nm/50 nm/100 nm/50 nm/3000 nm/10 nm.

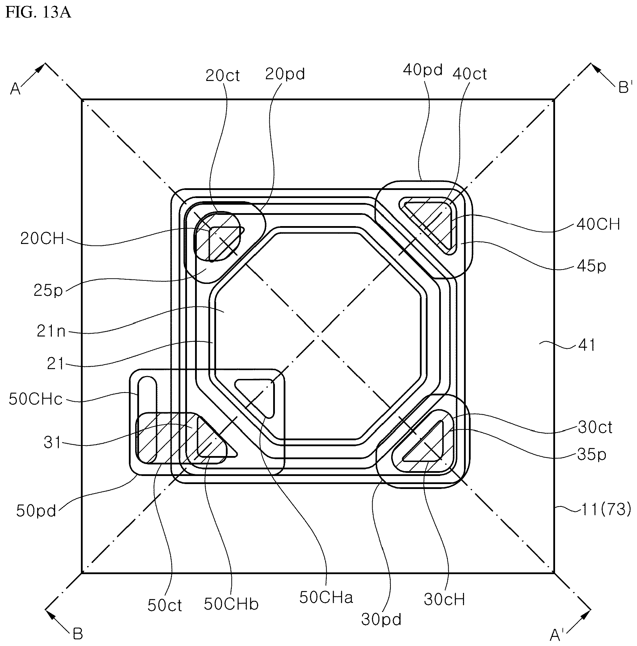

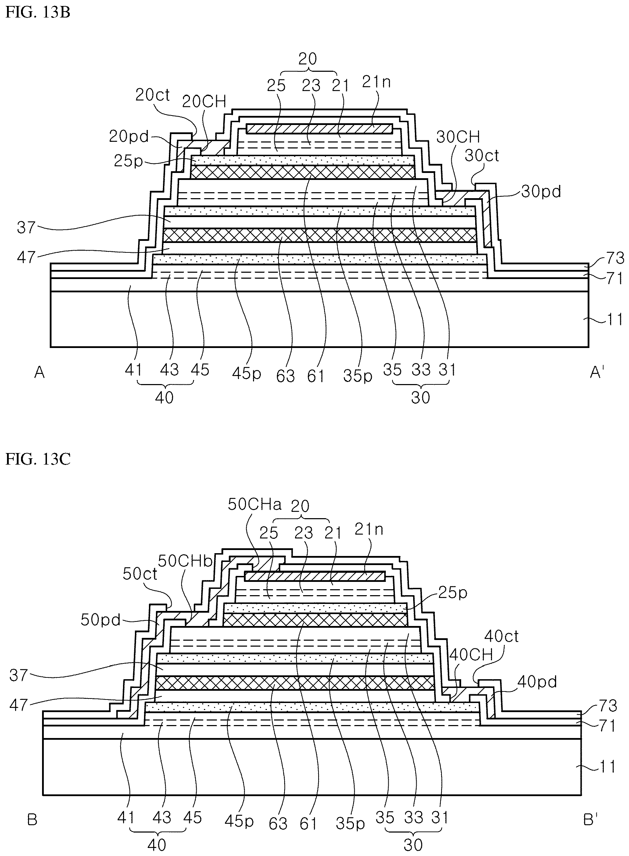

Referring to FIGS. 13A, 13B, and 13C, a second insulation layer 73 may be formed on the first insulation layer 71. The second insulation layer 73 may be formed of SiNx, SiO₂, Al₂O₃, or the like.

Subsequently, the second insulation layer 73 may be patterned to form first, second, third, and fourth through holes 20ct, 30ct, 40ct, and 50ct exposing the first through fourth pads 20pd, 30pd, 40pd, and 50pd.

The first through hole 20ct formed on the first pad 20pd exposes a portion of the first pad 20pd. The second through hole 30ct formed on the second pad 30pd exposes a portion of the second pad 30pd. The third through hole 40ct formed on the third pad 40pd exposes a portion of the third pad 40pd. The fourth through hole 50ct formed on the fourth pad 50pd exposes a portion of the fourth pad 50pd. In the illustrated exemplary embodiment, the first, second, third, and fourth through holes 20ct, 30ct, 40ct, and 50ct may be defined within regions in which the first, second, third, and fourth pads 20pd, 30pd, 40pd, and 50pd are formed, respectively. In addition, the first, second, third, and fourth through holes 20ct, 30ct, 40ct, and 50ct may be disposed at the outside of the first light emitting stack 20.

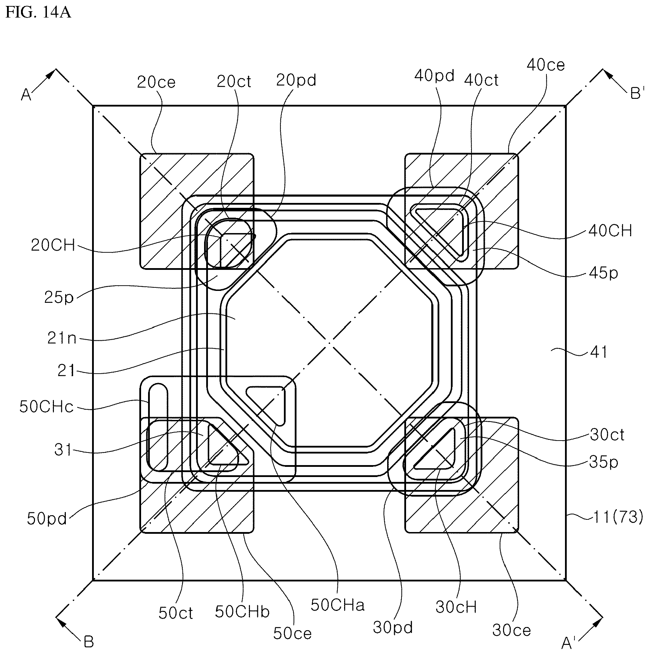

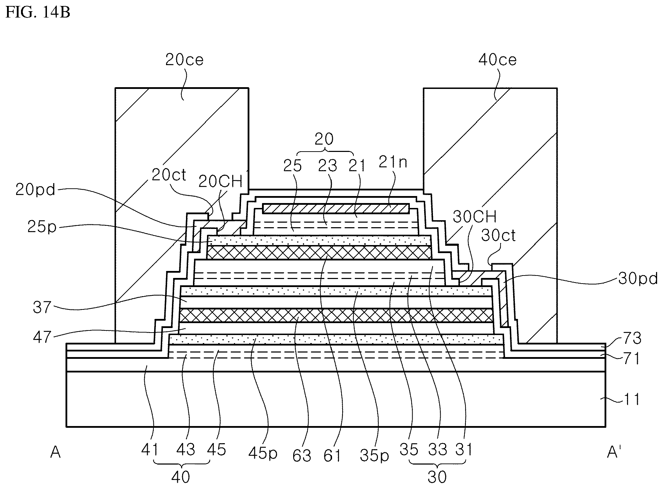

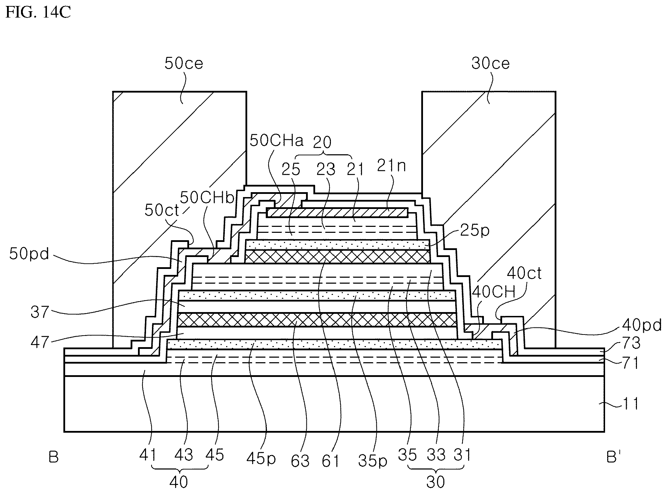

Referring to FIGS. 14A, 14B, and 14C, first, second, third, and fourth connection electrodes 20ce, 30ce, 40ce, and 50ce are formed on the second insulation layer 73 in which the first, second, third, and fourth through-holes 20ct, 30ct, 40ct, and 50ct are formed. The first connection electrode 20ce may be formed so as to overlap a region in which the first through hole 20ct is formed, and may be connected to the first pad 20pd through the first through hole 20ct. The second connection electrode 30ce may be formed so as to overlap a region where the second through hole 30ct is formed, and may be connected to the second pad 30pd through the second through hole 30ct. The third connection electrode 40ce may be formed so as to overlap a region in which the third through hole 40ct is formed, and may be connected to the third pad 40pd through the third through hole 40ct. The fourth connection electrode 50ce may be formed so as to overlap a region where the fourth through hole 50ct is formed, and may be connected to the fourth pad 50pd through the fourth through hole 50ct.

The first, second, third, and fourth connection electrodes 20ce, 30ce, 40ce, and 50ce may be spaced apart from one another and formed on the light emitting stacked structure. The first, second, third, and fourth connection electrodes 20ce, 30ce, 40ce, and 50ce may be electrically connected to the first, second, third, and fourth pads 20pd, 30pd, 40pd, and 50pd, respectively, to transmit an external signal to each of the light emitting stacks 20, 30, and 40.

A method of forming the first, second, third, and fourth connection electrodes 20ce, 30ce, 40ce, and 50ce is not particularly limited. For example, according to an exemplary embodiment of the present disclosure, a seed layer may be deposited as a conductive surface on the light emitting stacked structure, and a photoresist pattern may be formed such that the seed layer is exposed at a location where a connection electrode is to be formed. According to an exemplary embodiment, the seed layer may be deposited to have a thickness of about 1000 Å, without being limited thereto. The seed layer may be formed of, for example, Ti/Cu. Subsequently, the seed layer may be plated with a metal such as Cu, Ni, Ti, Sb, Zn, Mo, Co, Sn, Ag, or an alloy thereof. Cu is particularly easy to be plated and economical.

Meanwhile, after plating is completed, a polishing process may be performed so as to planarize an upper surface of the connection electrode. Thereafter, the photoresist pattern and the seed layer remaining between the connection electrodes may be removed. The polishing process may be omitted.

According to the illustrated exemplary embodiment, each of the connection electrodes 20ce, 30ce, 40ce, and 50ce may have a substantially elongated shape in a direction away from the substrate 11. In another exemplary embodiment, the first through fourth connection electrodes 20ce, 30ce, 40ce, and 50ce may include two or more metals or a plurality of different metal layers so as to reduce a stress from the elongated shape of the first through fourth connection electrodes 20ce, 30ce, 40ce, and 50ce. However, the present disclosure is not limited to specific shapes of the first through fourth connection electrodes 20ce, 30ce, 40ce, and 50ce, but in some exemplary embodiments, the connection electrodes may have various shapes.

The first through fourth connection electrodes 20ce, 30ce, 40ce, and 50ce may overlap at least one step formed on a side surface of the light emitting stacked structure. In this manner, a lower surface of the connection electrode may have a width larger than that of an upper surface, and it is possible to provide a larger contact area between the first through fourth connection electrodes 20ce, 30ce, 40ce, and 50ce and the light emitting stacked structure, and thus, that the unit pixel 100 may have a more stable structure capable of withstanding subsequent processes.

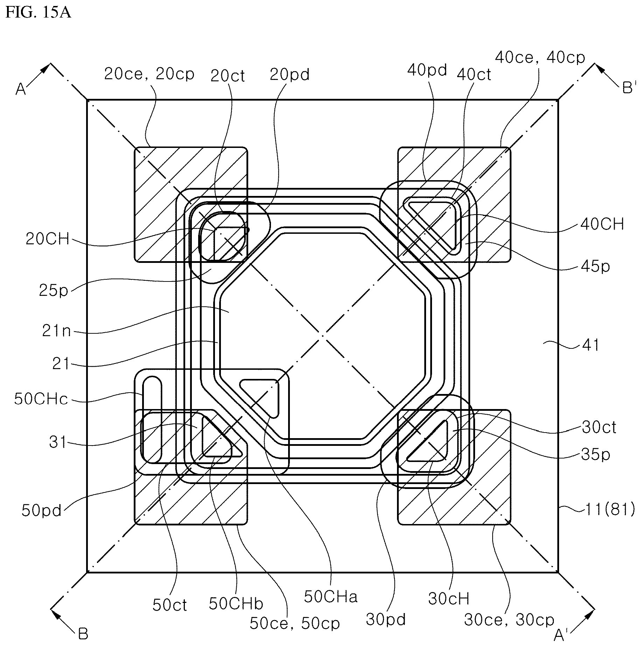

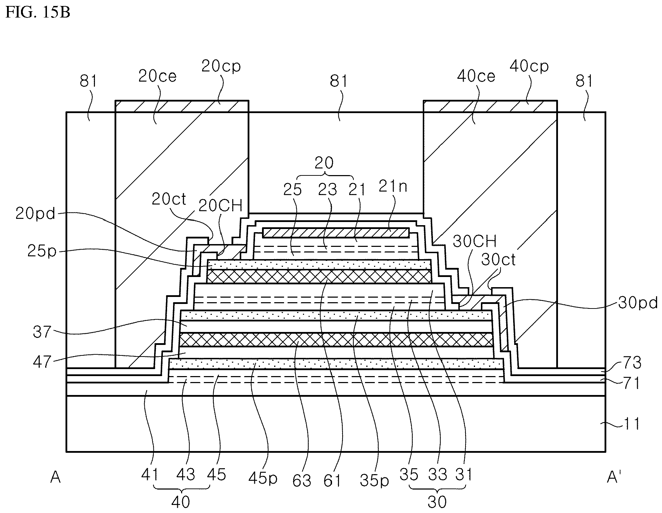

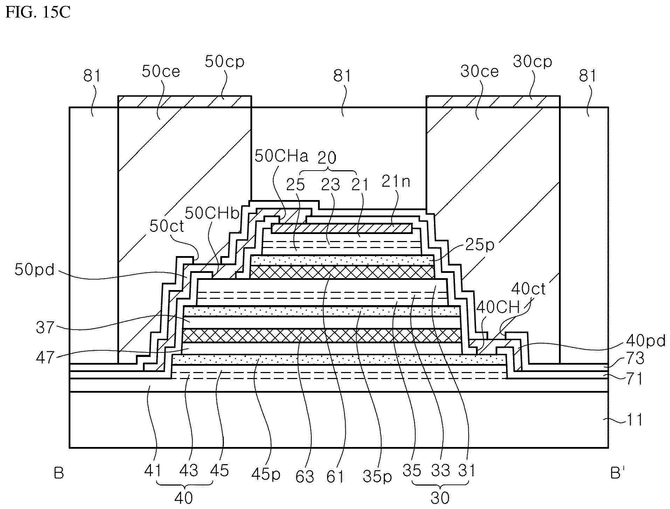

Referring to FIGS. 15A, 15B, and 15C, a protection layer 81 covering the first through fourth connection electrodes 20ce, 30ce, 40ce, and 50ce is formed. The protection layer 81 may fill a region between the first through fourth connection electrodes 20ce, 30ce, 40ce, and 50ce, and may cover side surfaces of the first through fourth connection electrodes 20ce, 30ce, 40ce, and 50ce. Furthermore, the protection layer 81 may be first formed so as to cover the upper surfaces of the first through fourth connection electrodes 20ce, 30ce, 40ce, and 50ce, and then, may be removed together with portions of upper regions of the first through fourth connection electrodes 20ce, 30ce, 40ce, and 50 using a grinding technique. For example, the first through fourth connection electrodes 20ce, 30ce, 40ce, and 50ce may be covered with an epoxy molding compound using a lamination technique, and after curing them, the epoxy molding compound may be removed using the grinding technique. Accordingly, an upper surface of the protection layer 81 may be formed flush with the upper surfaces of the first through fourth connection electrodes 20ce, 30ce, 40ce, and 50ce. In a particular exemplary embodiment, the upper surfaces of the first through fourth connection electrodes 20ce, 30ce, 40ce, and 50ce may slightly protrude than the upper surface of the protection layer 81.

Thereafter, bonding metal layers 20cp, 30cp, 40cp, and 50cp are formed on the first through fourth connection electrodes 20ce, 30ce, 40ce, and 50ce. The bonding metal layers 20cp, 30cp, 40cp, and 50cp having a multilayer structure of, for example, Ti/Ni/Au (50 nm/50 nm/400 nm) may be formed using a lift-off technique using a photoresist pattern exposing the upper surfaces of the first through fourth connection electrodes 20ce, 30ce, 40ce, and 50ce.

The bonding metal layers 20cp, 30cp, 40cp, and 50cp may be deposited using sputtering technology, and before the deposition, a pretreatment of removing natural oxide layers formed on the upper surfaces of the first through fourth connection electrodes 20ce, 30ce, 40ce, and 50ce may be performed using sulfuric acid. In an exemplary embodiment, the bonding metal layers 20cp, 30cp, 40cp, and 50cp may have an area smaller than an area of the upper surface of the first through fourth connection electrodes 20ce, 30ce, 40ce, and 50ce, respectively. In this case, the upper surfaces of the first through fourth connection electrodes 20ce, 30ce, 40ce, and 50ce may include a recessed region. In another exemplary embodiment, the bonding metal layers 20cp, 30cp, 40cp, and 50cp may have an area larger than the area of the upper surface of the first through fourth connection electrodes 20ce, 30ce, 40ce, and 50ce, respectively. Accordingly, portions of the bonding metal layers 20cp, 30cp, 40cp, and 50cp may be disposed on the protection layer 81.

Since the first through fourth connection electrodes 20ce, 30ce, 40ce, and 50ce are formed of a metal that is advantageous for plating, they may not be suitable for bonding. Furthermore, natural oxide layers are formed on the upper surfaces of the first through fourth connection electrodes 20ce, 30ce, 40ce, and 50ce, and thus, contact failure may occur. Accordingly, the natural oxide layers may be removed by partially removing the upper surfaces of the first through fourth connection electrodes 20ce, 30ce, 40ce, and 50ce, and in addition, the unit pixel 100 may be easily mounted on a circuit board using eutectic bonding technology by employing the bonding metal layers 20cp, 30cp, 40cp, and 50cp.

Thereafter, individualized unit pixels 100 may be completed by dividing the substrate 11 into unit pixel regions. The substrate 11 may be divided using a laser scribing technique. In other exemplary embodiments, the substrate 11 may be removed from the third light emitting stack 40.

The unit pixels 100 may be bonded onto the circuit board 1001 or a pixel substrate 2100 of FIG. 1 using the bonding metal layers 20cp, 30cp, 40cp, and 50cp to provide a display apparatus 10000. Accordingly, the unit pixels 100 are bonded such that the substrate 11 is disposed on a user's side in the display apparatus 10000, and light emitted from the first light emitting stack 20, the second light emitting stack 30, and the third light emitting stack 40 is emitted to the outside through the substrate 11.

FIG. 16A is a schematic plan view illustrating a shape of the unit pixel 100 according to an exemplary embodiment.

Referring to FIG. 16A, the first light emitting stack 20 may have a symmetrical structure with respect to an X-axis dividing an upper part from a lower part in plan view. In addition, the first light emitting stack 20 may have a symmetrical structure with respect to a Y axis dividing a left part from a right part in plan view. Accordingly, light emitted from the first light emitting stack 20 may exhibit a symmetrical emission pattern in the X-axis direction, and may also exhibit a symmetrical emission pattern in the Y-axis direction. In the exemplary embodiment, the first light emitting stack 20 has a regular octagonal shape. Accordingly, the emission pattern in the X-axis direction and the emission pattern in the Y-axis direction may be substantially similar. However, in the present embodiment, the shape of the first light emitting stack 20 is not limited to the regular octagon, but may be any octagon that is symmetrical left and right and up and down.

Meanwhile, the second light emitting stack 30 has a shape substantially similar to that of the first light emitting stack 20, but includes additional regions for electrical connection. For example, it may have protrusions in regions indicated by indication numerals 25p and 31 (for example, see FIG. 7A). Accordingly, the second light emitting stack 30 may have a symmetrical structure with respect to the X-axis, but may have an asymmetrical structure with respect to the Y-axis. However, the additional region of the second light emitting stack 30 is out of the X and Y axes. Accordingly, when only the second light emitting stack 30 on the X and Y axes is considered, the second light emitting stack 30 has the symmetrical structure. Accordingly, light emitted from the second light emitting stack 30 may also exhibit a generally symmetrical light emitting pattern in the X-axis direction and the Y direction.

Further, the third light emitting stack 40 has a shape including regions indicated by reference numerals 25p, 31, 35p, and 45p, that is, a rectangular or square shape, and thus, it has the symmetrical structure with respect to the X and Y axes. (For example, see FIG. 9A). Accordingly, light emitted from the third light emitting stack 40 may exhibit a generally symmetric light emitting pattern.

FIG. 16B is a schematic plan view illustrating a shape of the unit pixel according to another exemplary embodiment.

Referring to FIG. 16B, the first light emitting stack 20 may have a symmetrical structure with respect to an X-axis dividing an upper part from a lower part in plan view. In addition, the first light emitting stack 20 may have a symmetrical structure with respect to a Y axis dividing a left part from a right part in plan view. Accordingly, light emitted from the first light emitting stack 20 may exhibit a symmetrical emission pattern in the X-axis direction, and may also exhibit a symmetrical emission pattern in the Y-axis direction. In the illustrated exemplary embodiment, the first light emitting stack 20 has a regular hexagonal shape. However, in the present exemplary embodiment, the shape of the first light emitting stack 20 is not limited to the regular hexagon, but may be any hexagon that is symmetrical left and right and up and down.

Meanwhile, the second light emitting stack 30 has a shape substantially similar to that of the first light emitting stack 20, but includes additional regions for electrical connection. For example, it may have protrusions in regions indicated by indication numerals 25p and 31. Accordingly, the second light emitting stack 30 may have a symmetrical structure with respect to the X-axis, but may have an asymmetrical structure with respect to the Y-axis. However, the additional region of the second light emitting stack 30 is out of the X and Y axes. Accordingly, when only the second light emitting stack 30 on the X and Y axes is considered, the second light emitting stack 30 has the symmetrical structure. Accordingly, light emitted from the second light emitting stack 30 may also exhibit a generally symmetrical light emitting pattern in the X-axis direction and the Y direction.

Further, the third light emitting stack 40 has a shape including regions indicated by reference numerals 25p, 31, 35p, and 45p, that is, a rectangular or square shape, and thus, it has a symmetrical structure with respect to the X and Y axes. Accordingly, light emitted from the third light emitting stack 40 may exhibit a generally symmetric light emitting pattern.

FIG. 16C is a schematic plan view illustrating a shape of the unit pixel according to another exemplary embodiment.

Referring to FIG. 16C, the first light emitting stack 20 may have a symmetrical structure with respect to an X-axis dividing an upper part from a lower part in plan view. In addition, the first light emitting stack 20 may have a symmetrical structure with respect to a Y axis dividing a left part from a right part in plan view. Accordingly, light emitted from the first light emitting stack 20 may exhibit a symmetrical emission pattern in the X-axis direction, and may also exhibit a symmetrical emission pattern in the Y-axis direction. In the illustrated exemplary embodiment, the first light emitting stack 20 has a rhombus shape. In the illustrated exemplary embodiment, a length of the X-axis direction and a length of the Y-axis direction of the first light emitting stack 20 may be identical, without being limited thereto.

Meanwhile, the second light emitting stack 30 has a shape substantially similar to that of the first light emitting stack 20, but includes additional regions for electrical connection. For example, it may have protrusions in regions indicated by reference numerals 25p and 31. Accordingly, the second light emitting stack 30 may have a symmetrical structure with respect to the X-axis, but may have an asymmetrical structure with respect to the Y-axis. However, the additional region of the second light emitting stack 30 is out of the X and Y axes. Accordingly, when only the second light emitting stack 30 on the X and Y axes is considered, the second light emitting stack 30 has the symmetrical structure. Accordingly, light emitted from the second light emitting stack 30 may also exhibit a generally symmetrical light emitting pattern in the X-axis direction and the Y direction.

Further, the third light emitting stack 40 has a shape including regions indicated by reference numerals 25p, 31, 35p, and 45p, that is, a rectangular or square shape, and thus, has a symmetrical structure with respect to the X and Y axes. Accordingly, light emitted from the third light emitting stack 40 may exhibit a generally symmetric light emitting pattern.

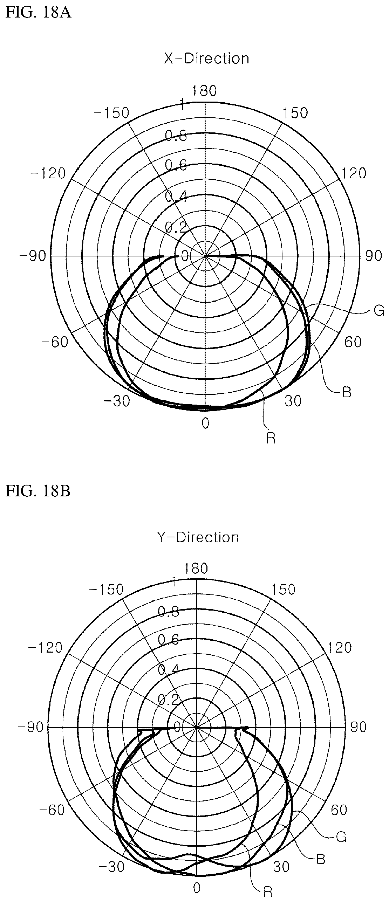

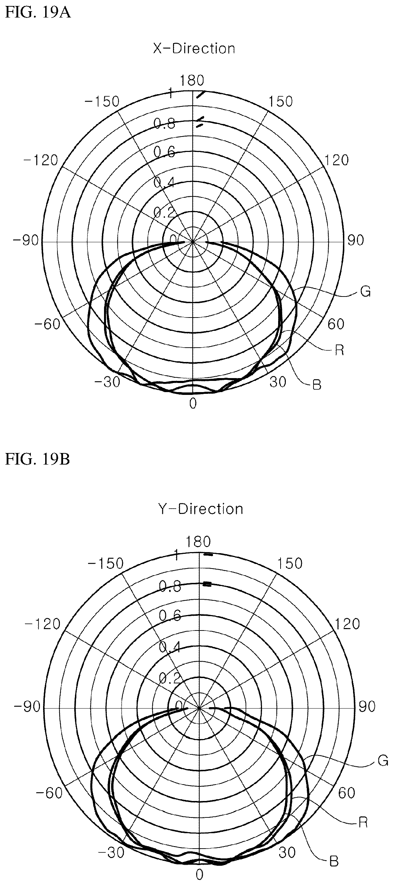

FIG. 17 is a schematic plan view showing a unit pixel 200 having light emitting devices R, G, and B arranged according to a prior art, FIGS. 18A and 18B are graphs illustrating light emission patterns in X and Y directions of the unit pixel according to the prior art, and FIGS. 19A and 19B are graphs illustrating light emission patterns in X and Y directions of the unit pixel according to an exemplary embodiment, respectively.

Referring to FIG. 17, the unit pixel 200 according to the prior art includes the light emitting devices R, G, and B arranged on a same plane. The light emitting devices may emit red light, green light, and blue light, respectively. As illustrated, a red light emitting device R and a blue light emitting device B are disposed on both sides in the Y-axis direction with a green light emitting device G as a center.

Referring to FIGS. 18A and 18B, the unit pixel 200 exhibits a generally symmetrical emission pattern in the X-axis direction, but exhibits a relatively asymmetrical emission pattern in the Y-axis direction. In particular, a symmetry of red light and blue light emitted from the red light emitting device R and the blue light emitting device B is less favorable than that of green light emitting device G disposed at the center.

Referring to FIGS. 19A and 19B, the unit pixel 100 according to an exemplary embodiment of the present disclosure exhibits symmetrical emission patterns in the X-axis direction and the Y-axis direction for all of red light, blue light, and green light.

Although certain exemplary embodiments and implementations have been described herein, other embodiments and modifications will be apparent from this description. Accordingly, the inventive concepts are not limited to such embodiments, but rather to the broader scope of the appended claims and various obvious modifications and equivalent arrangements as would be apparent to a person of ordinary skill in the art.

## Claims

1. A unit pixel, comprising:
a first light emitting stack;
a second light emitting stack disposed under the first light emitting stack; and
a third light emitting stack disposed under the second light emitting stack,
wherein at least one light emitting stack among the first through third light emitting stacks has a mirror symmetrical structure with respect to at least one vertical plane passing through a center of the at least one light emitting stack in plan view.

2. The unit pixel of claim 1, wherein:
the unit pixel has a rectangular shape in plan view, and
the at least one vertical plane passes through a straight line parallel to an edge of the unit pixel.

3. The unit pixel of claim 2,
wherein the first light emitting stack has a mirror symmetrical structure with respect to a vertical plane passing through a straight line parallel to a lateral edge of the unit pixel or a vertical plane passing through a straight line parallel to a vertical edge of the unit pixel.

4. The unit pixel of claim 3,
wherein the first light emitting stack has a mirror symmetrical structure with respect to each of the vertical plane passing through the straight line parallel to the lateral edge of the unit pixel and the vertical plane passing through the straight line parallel to the vertical edge of the unit pixel.

5. The unit pixel of claim 1,
wherein the first light emitting stack has an octagonal, hexagonal, or rhombus shape.

6. The unit pixel of claim 5,
wherein the first light emitting stack has a regular octagonal, regular hexagonal, or square shape.

7. The unit pixel of claim 2, wherein:
the second light emitting stack has a protrusion protruding to the outside of the first light emitting stack in plan view, and
the protrusion of the second light emitting stack is disposed in a diagonal direction of the unit pixel.

8. The unit pixel of claim 7,
wherein the second light emitting stack has a mirror symmetrical structure with respect to one of a vertical plane passing through a straight line parallel to a lateral edge of the unit pixel and a vertical plane passing through a straight line parallel to a vertical edge of the unit pixel, and has an asymmetrical structure with respect to the other one.

9. The unit pixel of claim 7,
wherein the third light emitting stack has a mirror symmetrical structure with respect to the vertical plane passing through the straight line parallel to the lateral edge of the unit pixel or the vertical plane passing through the straight line parallel to the vertical edge of the unit pixel.

10. The unit pixel of claim 9,
wherein the third light emitting stack has a rectangular shape.

11. The unit pixel of claim 2, further comprising:
first through fourth connection electrodes electrically connected to the first through third light emitting stacks,
wherein the first through fourth connection electrodes are disposed in a diagonal direction of the unit pixel.

12. The unit pixel of claim 11, further comprising:
a first insulation layer covering the first through third light emitting stacks;
first through fourth pads disposed on the first insulation layer; and
a second insulation layer covering the first through fourth pads, wherein:
the first insulation layer has contact holes allowing electrical connection to the first through third light emitting stacks,
the first through fourth pads are electrically connected to the first through third light emitting stacks through the contact holes,
the second insulation layer has through holes allowing electrical connection to the first through third pads, and
the first through fourth connection electrodes are electrically connected to the first through fourth pads through the through holes of the second insulation layer.

13. The unit pixel of claim 1, further comprising:
a first adhesive layer disposed between the first light emitting stack and the second light emitting stack;
a second adhesive layer disposed between the second light emitting stack and the third light emitting stack; and
a first adhesion enhancement layer disposed between the second adhesive layer and the second light emitting stack.

14. The unit pixel of claim 11, further comprising:
a second adhesion enhancement layer disposed between the second adhesive layer and the third light emitting stack.

15. The unit pixel of claim 14,
wherein the first adhesion enhancement layer and the second adhesion enhancement layer include a silicon oxide layer.

16. The unit pixel of claim 1, further comprising:
a substrate disposed under the third light emitting stack.

17. A display apparatus, comprising:
a circuit board;
a unit pixel disposed on the circuit board,
the unit pixel, comprising:
a first light emitting stack;
a second light emitting stack disposed under the first light emitting stack; and
a third light emitting stack disposed under the second light emitting stack,
wherein at least one light emitting stack among the first through third light emitting stacks has a mirror symmetrical structure with respect to at least one vertical plane passing through a center of the at least one light emitting stack in plan view.

18. The display apparatus of claim 17, wherein:
the unit pixel has a rectangular shape in plan view,
the at least one vertical plane passes through a straight line parallel to an edge of the unit, and
the first light emitting stack has a mirror symmetrical structure with respect to the at least one vertical plane.

19. The unit pixel of claim 18,
wherein the second light emitting stack has a mirror symmetrical structure with respect to one of a vertical plane passing through a straight line parallel to a lateral edge of the unit pixel and a vertical plane passing through a straight line parallel to a vertical edge of the unit pixel, and has an asymmetrical structure with respect to the other one.

20. The unit pixel of claim 19,
wherein the third light emitting stack has a mirror symmetrical structure with respect to the vertical plane passing through the straight line parallel to the lateral edge of the unit pixel or the vertical plane passing through the straight line parallel to the vertical edge of the unit pixel.
